# EUROPEAN PATENT APPLICATION

(11) **EP 4 834 826 A1**
(43) Date of publication of application: **04.11.2026**
(21) Application number: 24921720.9
(22) Date of filing: 09.12.2024
(51) Int. Cl.: B81B 7/02, G02B 26/08

(54) **MICROMIRROR CHIP, MICROMIRROR DEVICE AND OPTICAL DEVICE**

(30) Priority: 04.02.2024 CN 202410163132
(71) Applicant: Huawei Technologies Co., Ltd., Shenzhen, Guangdong 518129 (CN)
(72) Inventor: SUN, Fengpei, Shenzhen, Guangdong 518129 (CN); FENG, Zhihong, Shenzhen, Guangdong 518129 (CN); DING, Guanghui, Shenzhen, Guangdong 518129 (CN); XU, Jinghui, Shenzhen, Guangdong 518129 (CN); CHANG, Zhiwu, Shenzhen, Guangdong 518129 (CN)
(74) Representative: Isarpatent
(86) International application number: PCT/CN2024/137936
(87) International publication number: WO 2025/161698

(57) **Abstract**

The present disclosure provides a micromirror chip, a micromirror device, and an optical device, and pertains to the field of micro-electro-mechanical system technologies. The micromirror chip includes a substrate, a micromirror array, electrodes, an optical window, and a fixed ring. The micromirror array is located on a first surface of the substrate, the electrodes are located on a second surface of the substrate, and the first surface and the second surface are opposite in a thickness direction of the substrate. The fixed ring is fastened onto the first surface of the substrate, the micromirror array is located in inner space of the fixed ring, and the optical window is fastened onto the fixed ring and covers the micromirror array. During packaging of the micromirror chip, because the micromirror array is first sealed in a sealed space formed by the substrate, the fixed ring, and the optical window, in a subsequent packaging process, no small particles fall into an environment in which the micromirror array is located, so that a qualification rate of the packaged micromirror device can be improved, thereby improving a yield rate of the packaged micromirror device.

## Description

The present disclosure claims priority to Chinese Patent Application No. 202410163132.X, filed on February 4, 2024 and entitled "MICROMIRROR CHIP, MICROMIRROR DEVICE, AND OPTICAL DEVICE", which is incorporated herein by reference in its entirety.

### TECHNICAL FIELD

The present disclosure relates to the field of micro-electro-mechanical system technologies, and in particular, to a micromirror chip, a micromirror device, and an optical device.

### BACKGROUND

A micromirror chip, for example, a micro-electro-mechanical system (micro-electro-mechanical system, MEMS) micromirror chip, is a device used to change an optical path, has advantages such as a small size and high responsiveness, and is widely used in fields such as optical communication, lidar, and optical projection.

In a packaging process of the micromirror chip, for example, in a process of fastening a micromirror die onto a base plate and in a process of bonding gold wires on the micromirror die, the micromirror die may become contaminated. For example, small particles may fall onto the micromirror die. Consequently, a yield rate of a packaged micromirror device is reduced.

### SUMMARY

The present disclosure provides a micromirror chip, a micromirror device, and an optical device, to improve a yield rate of a packaged micromirror device.

According to a first aspect, the present disclosure provides a micromirror chip. The micromirror chip includes a substrate, a micromirror array, electrodes, an optical window, and a fixed ring.

The micromirror array is located on a first surface of the substrate, the electrodes are located on a second surface of the substrate, and the first surface and the second surface are opposite in a thickness direction of the substrate.

The fixed ring is fastened onto the first surface of the substrate, the micromirror array is located in inner space of the fixed ring, and the optical window is fastened onto the fixed ring and covers the micromirror array.

In the solution shown in the present disclosure, during packaging of the micromirror chip, because the micromirror array is first sealed in a sealed space formed by the substrate, the fixed ring, and the optical window, in a subsequent packaging process, no small particles fall into an environment in which the micromirror array is located, so that a qualification rate of a packaged micromirror device can be improved, thereby improving a yield rate of the packaged micromirror device.

In a possible implementation, the optical window is in a flat plate shape, an included angle α is formed between the optical window and the substrate, and the included angle α is greater than a maximum rotation angle β of rotatable micromirrors in the micromirror array.

The maximum rotation angle β is a maximum rotation angle of all rotatable micromirrors. For example, maximum rotation angles of all the rotatable micromirrors are the same, that is, β. For another example, maximum rotation angles of all the rotatable micromirrors are different, but β is a largest maximum rotation angle.

In the solution shown in the present disclosure, regardless of how many degrees the rotatable micromirror rotates, the optical window is not parallel to the rotatable micromirror. A reflection optical path of the optical window does not fall within a range of a scanning field of view of the rotatable micromirror, provided that the optical window is not parallel to the rotatable micromirror. A detector is disposed within the range of the scanning field of view of the rotatable micromirror. Therefore, the detector can be only in the scanning field of view of the rotatable micromirror, instead of being on the reflection optical path of the optical window, so that light reflected by the optical window does not enter the detector. In this way, even if the optical window has a specific reflectivity, the light reflected by the optical window does not cause interference to an optical signal received by the detector.

For example, each micromirror in the micromirror array corresponds to one coupler, one optical fiber, and one detector. Light reflected by the micromirror enters the coupler, enters the optical fiber through the coupler, and then is incident to the detector through the optical fiber. To prevent light reflected by the optical window from entering the detector, the light reflected by the optical window only needs to be prevented from entering the coupler or enter the coupler at a large angle of incidence. The angle of incidence herein is an included angle between the light and a normal of the coupler. A smaller angle of incidence indicates that the light is incident on the coupler more perpendicularly, and coupling efficiency is higher. However, in this case, it is intended that the light reflected by the optical window is coupled to the coupler at low efficiency.

In a possible implementation, a height of the fixed ring satisfies the following relationship: $L 1 / H 1 \geq tan \left(θ\right) , and L 2 / H 2 \geq tan \left(θ+2γ\right) .$

L1 is a minimum spacing between the fixed ring and a first micromirror that is close to a direction of incident light and that is located at an array edge of the micromirror array, and H1 is a height of the fixed ring near the first micromirror.

L2 is a minimum spacing between the fixed ring and a second rotatable micromirror that is close to a direction of emergent light and that is located at an array edge of the micromirror array, and H2 is a height of the fixed ring near the second rotatable micromirror.

θ is a maximum included angle between incident light and a normal of a horizontal plane on which the substrate is located, and γ is a maximum rotation angle of the second rotatable micromirror.

In the solution shown in the present disclosure, when a size of the fixed ring satisfies: L1/H1≥tan(θ), light at any angle of incidence can be incident to any micromirror in the micromirror array. When the size of the fixed ring satisfies: L2/H2≥tan(θ+2γ), light reflected by any micromirror can be emitted from the micromirror chip.

In a possible implementation, a first recess is formed on an inner surface of the optical window at a position close to an edge, and the top of the fixed ring is fastened in the first recess.

In the solution shown in the present disclosure, the first recess is used to enhance fastening strength between the optical window and the fixed ring, and implement pre-positioning between the optical window and the fixed ring, to prevent the optical window from sliding from the top of the fixed ring, or avoid slippage between the optical window and the fixed ring.

In a possible implementation, a second recess is formed on an inner surface of the fixed ring at a top position, and the inner surface of the optical window is fastened in the second recess at a position close to an edge.

In the solution shown in the present disclosure, the second recess is used to enhance fastening strength between the optical window and the fixed ring, and implement pre-positioning between the optical window and the fixed ring, to prevent the optical window from sliding from the top of the fixed ring, or avoid occurrence of slippage between the optical window and the fixed ring.

In a possible implementation, breather holes/a breather hole are/is formed in the fixed ring and/or the optical window, and the breather hole is used to allow the inner space of the fixed ring to be in communication with outer space of the fixed ring before a high-temperature packaging process, and is sealed by using a medium after the high-temperature packaging process.

In the solution shown in the present disclosure, during packaging of the micromirror chip, in the high-temperature process, for example, when the micromirror chip is welded on a base plate or welded on an RDL, even at a high temperature, because of the breather hole, atmospheric pressure in the inner space of the fixed ring can be reduced, and a component in the inner space of the ring is prevented from being damaged in high pressure.

In the solution shown in the present disclosure, after the high-temperature process, the breather hole may be sealed by filling the medium in the breather hole, to ensure that the inner space of the fixed ring is in a sealed state.

In a possible implementation, a breather hole is formed in the optical window, and a part of a vertical projection of the breather hole on the substrate falls in the inner space of the fixed ring, and the other part falls on the fixed ring.

In the solution shown in the present disclosure, when the breather hole is sealed through dispensing, glue may adhere to the fixed ring, and almost does not fall into the inner space of the fixed ring.

In a possible implementation, a chamfer is formed on the inner surface that is at the top of a ring wall of the fixed ring and that is connected to the optical window.

In the solution shown in the present disclosure, the chamfer can provide clearance for incident light and emergent light.

In a possible implementation, the ring wall of the fixed ring has a trapezoidal column shape, and an area of the top close to the optical window is smaller than an area of the bottom of the ring wall of the fixed ring close to the substrate.

In the solution shown in the present disclosure, the area of the top of the fixed ring is smaller than the area of the bottom of the fixed ring, to provide clearance for incident light and emergent light, and increase strength of the ring wall of the fixed ring.

In a possible implementation, an antireflective film is coated on each of an outer surface and the inner surface of the optical window, and no antireflective film is disposed at a position at which the inner surface of the optical window is fastened onto the fixed ring.

In the solution shown in the present disclosure, there is no antireflective film at the position at which the inner surface of the optical window is fastened onto the fixed ring, so that to avoid impact of the antireflective film on fastening the optical window onto the fixed ring, so that the optical window and the fixed ring are fastened more firmly.

In a possible implementation, a groove is formed at a position at which the first surface of the substrate is fastened onto the fixed ring, and the bottom of the fixed ring is fastened in the groove.

In the solution shown in the present disclosure, groove walls around the groove and a groove bottom of the groove are each in a fastening relationship with the fixed ring. Therefore, compared with a solution in which the fixed ring is directly fastened onto the surface of the substrate, the solution in which the groove is formed can clearly increase a contact area between the substrate and the fixed ring, thereby enhancing adhesion (for example, glue adhesion) between the substrate and the fixed ring, and enhancing fastening strength between the substrate and the fixed ring. Once the fastening strength between the substrate and the fixed ring is enhanced, bonding strength between the substrate and the fixed ring is also enhanced, and airtightness of the inner space of the fixed ring is also enhanced.

In a possible implementation, roughness at the position at which the first surface of the substrate is fastened onto the fixed ring is greater than roughness at another position.

In the solution shown in the present disclosure, when the fixed ring is fastened onto the substrate at the position with large roughness, adhesion between the substrate and the fixed ring can be enhanced based on the large roughness, thereby enhancing fastening strength between the substrate and the fixed ring.

In a possible implementation, a spacing between the optical window and a first side of the substrate is greater than or equal to 100 µm.

In the solution shown in the present disclosure, the optical window is fastened onto the substrate of a micromirror die. However, the spacing between the optical window and the substrate may be set, for example, to be large enough, so that the optical window does not interfere with rotation of the rotatable micromirrors in the micromirror array.

In a possible implementation, a material of the fixed ring is glue, a silicon material, or a metal material.

In the solution shown in the present disclosure, the fixed ring may be made of glue. After the glue is cured, a fixed ring in a ring shape is formed.

In a possible implementation, the fixed ring and the substrate are fastened through gluing or bonding, and the optical window and the fixed ring are fastened through gluing or bonding.

In the solution shown in the present disclosure, the fixed ring may alternatively be made of a silicon material or a metal material. In this case, the fixed ring is fixedly connected to the substrate through gluing or bonding, and the optical window is also fixedly connected to the fixed ring through a gluing or bonding process.

In a possible implementation, the micromirror chip further includes a getter, and the getter is located in the inner space of the fixed ring.

In the solution shown in the present disclosure, the getter located in a sealed space formed by the substrate, the fixed ring, and the optical window can absorb gas, such as moisture, in the sealed space, to prevent the gas from affecting rotation of the rotatable micromirrors in the micromirror array.

In a possible implementation, the electrodes include a first electrode and second electrodes that are configured to drive the rotatable micromirrors in the micromirror array to rotate. The first electrode is located on the first surface of the substrate and in outer space of the fixed ring, and the second electrode is located on the second surface of the substrate. There are one or more first electrodes. For example, a quantity of first electrodes is less than or equal to a quantity of second electrodes. The quantity of second electrodes is greater than or equal to a quantity of rotatable micromirrors included in the micromirror array.

In the solution shown in the present disclosure, the first electrode may be a negative electrode, the second electrode may be a positive electrode, and the rotatable micromirrors in the micromirror array may share one first electrode. Therefore, the quantity of first electrodes is small, and the first electrodes may be disposed on the first surface of the substrate, and are on a same side as the micromirror array. Although the first electrode is on the same side as the micromirror array, the first electrode is in the outer space of the fixed ring, and therefore, does not affect a connection between the first electrode and a peripheral circuit during packaging of the micromirror chip.

In another shown solution, there may be a plurality of first electrodes used as negative electrodes. The quantity of second electrodes used as positive electrodes may be the same as the quantity of rotatable micromirrors, and one second electrode corresponds to one rotatable micromirror. Alternatively, the quantity of second electrodes may be greater than the quantity of rotatable micromirrors, and a plurality of second electrodes correspond to one rotatable micromirror.

In a possible implementation, the electrodes include a first electrode and second electrodes that are configured to drive the rotatable micromirrors in the micromirror array to rotate. Both the first electrode and the second electrode are located on the second surface of the substrate. There are one or more first electrodes. For example, a quantity of first electrodes is less than or equal to a quantity of second electrodes. The quantity of second electrodes is the same as a quantity of rotatable micromirrors included in the micromirror array, or the quantity of second electrodes is greater than a quantity of rotatable micromirrors. For example, the quantity of second electrodes is an integer multiple of the quantity of rotatable micromirrors.

In the solution shown in the present disclosure, all electrodes of the micromirror chip, that is, the first electrode and the second electrode, are disposed on the second surface of the substrate, and on a side of the substrate different from that on which the micromirror array is disposed. In this case, the electrodes of the micromirror chip are located in the outer space of the fixed ring, and do not affect a connection between each of the first electrode and the second electrode and a peripheral circuit during packaging of the micromirror chip.

In a possible implementation, the micromirror chip further includes an electrode lead-out layer. The electrode lead-out layer is located on the second surface of the substrate, electrodes are disposed on the electrode lead-out layer, and the electrodes on the electrode lead-out layer are electrically connected to the electrodes on the second surface of the substrate.

In a possible implementation, the electrode lead-out layer is a through-silicon via TSV layer, annular regions extending in the thickness direction are formed on the TSV layer, and a quantity of annular regions is greater than or equal to a quantity of electrodes on the second surface of the substrate.

The TSV layer is electrically conductive, each electrode on the second surface of the substrate is electrically connected to an inner ring region enclosed by an inner ring of one annular region, and the annular region is filled with an insulating first medium.

In the solution shown in the present disclosure, the inner ring region enclosed by the inner ring of the annular region forms the electrode on the TSV layer, and the annular region is filled with the insulating first medium, to implement electrical isolation between two adjacent inner ring regions.

In the solution shown in the present disclosure, because a material of the substrate is silicon, and a material of the TSV layer is also silicon, the TSV layer may also be considered as a part of the substrate of the micromirror die. In this case, the micromirror die also includes the TSV layer, that is, the TSV layer is also a part of the micromirror die.

In this solution in which the micromirror chip includes the TSV layer, the TSV layer has a specific thickness. Therefore, the TSV layer can increase an overall thickness of the micromirror die. Once the overall thickness of the micromirror die is large, rigidity of the micromirror die is high, and deformation is less likely to occur in a packaging process.

In a possible implementation, the electrodes on the second surface of the substrate include drive electrodes and a test electrode, the drive electrodes are configured to drive the rotatable micromirrors in the micromirror array to rotate, and the test electrode is configured to test conductivity of the TSV layer and a connected base plate or RDL.

In the solution shown in the present disclosure, an example in which the TSV layer is connected to the RDL is used, and each inner ring region of the TSV layer is connected to the RDL. In this case, testing the connectivity between the TSV layer and the connected RDL means testing connectivity at a position at which the inner ring region is connected to the RDL. For example, if the inner ring region is connected to the RDL through a solder ball, conductivity between the solder ball and the inner ring region and conductivity between the solder ball and the RDL are tested.

It should be noted that, not conductivity between all inner ring regions and the RDL is tested, because a part of the inner ring regions is connected to the drive electrode. For example, there are eight inner ring regions. Five inner ring regions are connected to the drive electrodes, to input drive signals to the rotatable micromirrors, and three inner ring regions are connected to the test electrode (for example, connected in series on a test link). In this case, when connectivity is tested, connectivity between the inner ring regions on the test link and the RDL is tested.

In a possible implementation, there are one or more test electrodes (for example, a quantity of test electrodes is an odd number), and all test electrodes may be positive electrodes. To form the test link, one of the drive electrodes may be used as a negative electrode. For example, one of the foregoing first electrodes may be used as the negative electrode on the test link. In this way, each test electrode is connected to one first electrode, to form a closed circuit for testing. Alternatively, all test electrodes are grounded to form the test link.

In a possible implementation, there are two or more test electrodes (for example, a quantity of test electrodes is an even number). For example, two pairs of test electrodes are included. In each pair of test electrodes, one electrode is used as a positive electrode, and the other electrode is used as a negative electrode. In this way, the positive electrode and the negative electrode in each pair of test electrodes are connected to form a closed short circuit for testing.

In the test, a resistance meter is used to test resistance in the short-circuit loop. If the resistance is large, it indicates that conductivity of at least one connection position on the test link is poor. If the resistance is small, it indicates that conductivity of all connection positions on the test link is good.

It should be noted that a positive electrode and a negative electrode on a drive link that are configured to drive the rotatable micromirror to rotate are separately connected to a driver chip, so that the driver chip drives the rotatable micromirror to rotate. Alternatively, a positive electrode on a drive link that is configured to drive the rotatable micromirror to rotate is connected to a positive electrode of a driver chip, and a negative electrode on the drive link and a negative electrode of the driver chip are connected to a common ground.

In a possible implementation, an inner ring wall and an outer ring wall of the annular region are each covered with the first medium.

A second medium is further filled between the first medium on the inner ring wall and the first medium on the outer ring wall, and a coefficient of thermal expansion of the second medium is between a coefficient of thermal expansion of the first medium and a coefficient of thermal expansion of a material in the inner ring region.

In the solution shown in the present disclosure, the annular region is not completely filled with the first medium, but filled with the first medium and the second medium. The first medium achieves a function of electric isolation, and the second medium achieves a function of reducing thermal stress.

In a possible implementation, a material of the second medium is polycrystalline silicon, for example, doped polycrystalline silicon.

In a possible implementation, a material of the TSV layer is monocrystalline silicon, and a material of the first medium is silicon oxide.

In the solution shown in the present disclosure, the material of the TSV layer is monocrystalline silicon, the material of the first medium is silicon oxide, the material of the second medium is polycrystalline silicon, and both the TSV layer and the second medium are made of silicon materials. In this case, coefficients of thermal expansion of the TSV layer and the second medium are close, and thermal stress between the TSV layer and the second medium is small. Therefore, the micromirror chip is less likely to be deformed under a temperature change.

In a possible implementation, the electrode lead-out layer is an electrode chip, and the area of the electrode chip is larger than an area of the substrate.

An electrode is disposed at a position that extends out of the substrate and that is on an upper surface of the electrode chip, and the upper surface of the electrode chip is a surface facing the second surface of the substrate.

The electrode on the upper surface of the electrode chip is electrically connected to the electrode on the second surface of the substrate through a routing trace inside the electrode chip.

According to a second aspect, a micromirror device is provided. The micromirror device includes a base plate, a driver chip, and the micromirror chip according to the first aspect.

The micromirror chip is located on the base plate, and the driver chip is electrically connected to the micromirror chip.

In the solution shown in the present disclosure, the micromirror chip is electrically connected to the base plate or an RDL through a solder ball. Compared with a solution in which the micromirror chip is connected to the base plate or the RDL through a pin connector, the solution in which an electrical connection is implemented through the solder ball is more conducive to achieving high-density arrangement, because the solder ball is small in size and a spacing between adjacent solder balls is small.

In a possible implementation, the micromirror device further includes a re-distribution layer RDL, the RDL is located on a surface of the base plate, the micromirror chip is located on an upper surface of the RDL, and the upper surface of the RDL is a surface facing away from the base plate.

In the solution shown in the present disclosure, because a material of the RDL is silicon, even if an area of the RDL is large, a surface of the RDL is still flat, and the micromirror chip can be easily fastened onto the surface of the RDL.

In a possible implementation, the driver chip is located on the upper surface of the RDL, and the micromirror chip is electrically connected to the driver chip through the RDL.

In the solution shown in the present disclosure, the driver chip and the micromirror chip are located on an upper surface of a same RDL. In this way, the driver chip is electrically connected to the micromirror chip through a routing trace inside the RDL. Alternatively, RDLs include a first RDL and a second RDL, the micromirror chip is located on the first RDL, the driver chip is located on the second RDL, and the first RDL is connected to the second RDL through wire bonding. In this way, the driver chip is separately welded on one RDL. In this case, even if an error occurs in a process of welding one driver chip on the second RDL, the micromirror chip and another driver chip are not affected, so that a yield rate loss can be reduced, and a yield rate of the micromirror device can be improved.

In a possible implementation, the micromirror device further includes a connector, and the connector is located on a surface of the base plate, for example, located on an upper surface or a lower surface of the base plate.

The micromirror chip and the connector are electrically connected to the base plate through the RDL, and the connector is electrically connected to the driver chip through a flexible printed circuit FPC.

In a possible implementation, a lower surface of the RDL has a plurality of anchor structures and a plurality of elastic structures, the anchor structures are connected to the elastic structures in a one-to-one manner, and the lower surface of the RDL is a surface facing the base plate.

The RDL is fastened onto the base plate at a position of the anchor structure by using a first adhesive, the RDL is fastened onto the base plate at a position other than the anchor structure by using a second adhesive, an elastic modulus of the first adhesive is greater than an elastic modulus of the second adhesive, and the second adhesive is flexible after being cured.

In the solution shown in the present disclosure, an epoxy resin adhesive has high rigidity after being cured, so that the RDL is more firmly fastened onto the base plate. Thermally conductive silicone is soft after being cured, so that stress generated during bonding between the RDL and the base plate can be released, and residual stress between the RDL and the base plate can be reduced. Therefore, after the RDL is bonded to the base plate, deformation is less likely to occur.

According to a third aspect, an optical device is provided. The optical device includes a laser and the micromirror device according to the second aspect, the laser is configured to emit an optical signal, and the micromirror device is configured to reflect an optical signal.

### BRIEF DESCRIPTION OF DRAWINGS

FIG. 1 is a diagram of a micromirror chip according to an example embodiment of the present disclosure;
FIG. 2 is a top view of a micromirror chip according to an example embodiment of the present disclosure;
FIG. 3 is a diagram of a micromirror chip in which a first electrode is on a first side of a substrate and second electrodes are on a second side of the substrate according to an example embodiment of the present disclosure;
FIG. 4 is a diagram of a micromirror chip in which both a first electrode and second electrodes are on a second side of a substrate according to an example embodiment of the present disclosure;
FIG. 5 is a diagram of a micromirror chip in which an included angle is formed between an optical window and a substrate according to an example embodiment of the present disclosure;
FIG. 6 is a diagram in which a fixed ring is fastened onto a substrate according to an example embodiment of the present disclosure;
FIG. 7 is a diagram of a scanning field of view of light on a micromirror chip according to an example embodiment of the present disclosure;
FIG. 8 is a diagram of a micromirror chip in which a first recess is formed on an optical window according to an example embodiment of the present disclosure;
FIG. 9 is a diagram of a micromirror chip in which a second recess is formed on a fixed ring according to an example embodiment of the present disclosure;
FIG. 10 is a diagram of a micromirror chip in which a recess is formed on each of an optical window and a fixed ring according to an example embodiment of the present disclosure;
FIG. 11 is a diagram of a micromirror chip in which a groove is formed on a substrate according to an example embodiment of the present disclosure;
FIG. 12 is a top view of a micromirror chip including a getter according to an example embodiment of the present disclosure;
FIG. 13 is a diagram of a micromirror chip including a TSV layer according to an example embodiment of the present disclosure;
FIG. 14 is a top view of a region near an annular region in FIG. 13;
FIG. 15 is a diagram of a micromirror chip including an electrode chip according to an example embodiment of the present disclosure;
FIG. 16 is a diagram in which a micromirror chip is packaged on a base plate according to an example embodiment of the present disclosure;
FIG. 17 is a diagram in which both a micromirror chip and driver chips are packaged on a base plate according to an example embodiment of the present disclosure;
FIG. 18 is a diagram in which a micromirror chip is packaged on a base plate through an RDL according to an example embodiment of the present disclosure;
FIG. 19 is a diagram in which both a micromirror chip and driver chips are packaged on a base plate through a same RDL according to an example embodiment of the present disclosure;
FIG. 20 is a diagram in which a micromirror chip and driver chips are packaged on a base plate through different RDLs according to an example embodiment of the present disclosure;
FIG. 21 is a diagram in which a micromirror chip is externally connected through a connector according to an example embodiment of the present disclosure;
FIG. 22 is a diagram in which both a micromirror chip and a driver chip are packaged on a base plate through an RDL, and the driver chip is externally connected through a connector according to an example embodiment of the present disclosure;
FIG. 23 is a diagram in which an RDL is fastened onto a base plate according to an example embodiment of the present disclosure;
FIG. 24 shows a curve of a deformation change relationship of an RDL in a solution in which the RDL is bonded to a base plate by using an epoxy resin adhesive; and
FIG. 25 shows a curve of a deformation change relationship of an RDL in a solution in which the RDL is fastened onto a base plate at an anchor structure position by using an epoxy resin adhesive, and fastened onto the base plate at another position by using thermally conductive silicone.

### Reference numerals:

1. Substrate; 2. Micromirror array; 21. Micromirror; 21A: First micromirror; 21B: Second micromirror;
3. Electrode; 31. First electrode; 32. Second electrode; 4. Optical window;
5. Fixed ring; 51. First side wall; 52. Second side wall; 53. Third side wall; 54. Fourth side wall;
6. Getter;
7. TSV layer; 71. Annular region; 72. Inner ring region; 73. First medium; 74. Second medium; 8. Electrode chip;
100. Base plate; 200. Driver chip; 300. Micromirror chip; 400. RDL; and 500. Connector.

### DESCRIPTION OF EMBODIMENTS

To make the objectives, technical solutions, and advantages of the present disclosure clearer, the following further describes the implementations of the present disclosure in detail with reference to the accompanying drawings.

Embodiments of this application relate to a micromirror chip, and the micromirror chip is specifically a micro-electro-mechanical system (micro-electro-mechanical system, MEMS) micromirror chip. During processing of the micromirror chip, a micromirror die is generally first manufactured through a semiconductor process, and then the micromirror die is packaged to obtain a packaged micromirror device. The packaged micromirror device is then used in optical devices (such as a laser ranging radar, an optical cross connect, and a wavelength selective switch).

In an entire packaging process of the micromirror die, all micromirrors of the micromirror die are exposed. As a result, some small particles fall in an environment in which the micromirror is located, and these small particles interfere with rotation of the micromirror. In addition, the small particles are electrically charged, affecting a drive signal of the micromirror. It can be learned that, regardless of whether the small particles interfere with rotation of the micromirror or affect a drive signal of the micromirror, a yield rate of the packaged micromirror device is reduced.

To improve a yield rate of a packaged micromirror device, an embodiment provides a micromirror chip. Before the micromirror chip is packaged on a base plate, a micromirror is sealed to protect the micromirror. In this way, in a packaging process, small particles can be prevented from falling into an environment in which the micromirror is located, thereby improving the yield rate of the packaged micromirror device.

In this embodiment, a chip processed through a semiconductor process is referred to as a micromirror die, a chip onto which an optical window 4 is fastened is referred to as a micromirror chip, and a chip packaged on a base plate is referred to as a micromirror device.

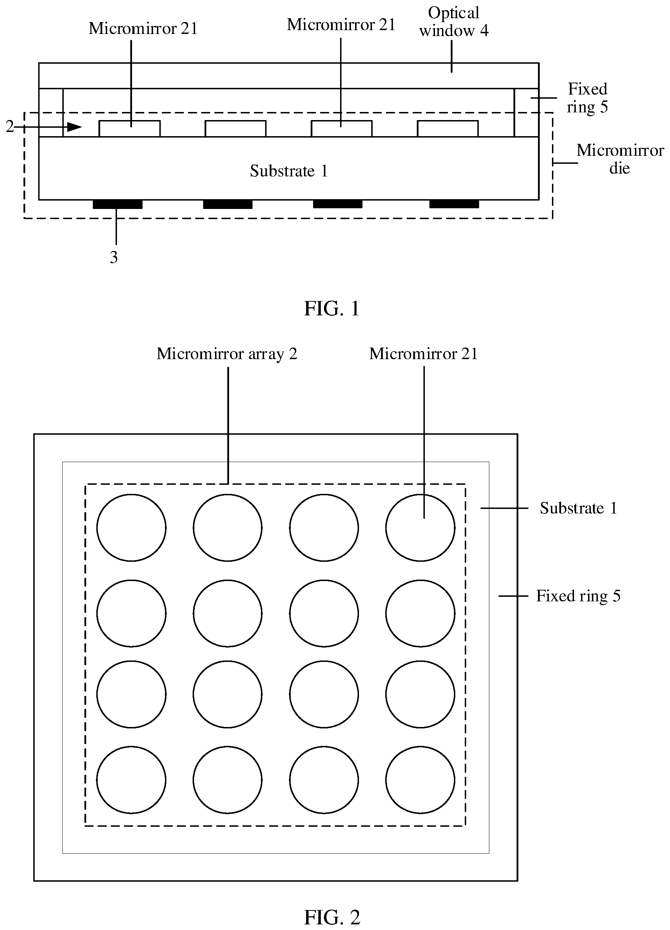

The following describes features of the micromirror chip. FIG. 1 and FIG. 2 are structural diagrams of the micromirror chip. FIG. 2 is a top view of the micromirror chip. A structure in a dashed box in FIG. 1 is the micromirror die processed through the semiconductor process, and is also referred to as a micromirror bare die.

Refer to FIG. 1. The micromirror chip includes a substrate 1 and a micromirror array 2. The substrate 1 may be specifically a silicon substrate. Refer to FIG. 2, the micromirror array 2 is an array including a plurality of micromirrors 21, and is located on a first surface of the substrate 1. For example, a plurality of micromirror recesses are formed on the first surface of the substrate 1, and one micromirror is disposed in each micromirror recess.

The micromirror 21 is a micro optical mirror whose size is at a micrometer to millimeter level, and is configured to change an optical path of an optical signal.

In an example, the plurality of micromirrors 21 in the micromirror array 2 may all be rotatable micromirrors (denoted as rotatable micromirrors), and these rotatable micromirrors can rotate under a drive signal.

In another example, in the plurality of micromirrors 21 in the micromirror array 2, some micromirrors 21 may be non-rotatable micromirrors (that is, fixed micromirrors), while the other micromirrors may be rotatable micromirrors. As described above, the rotatable micromirror rotates under the drive signal, while the fixed micromirror, once fabricated, cannot rotate.

For example, the fixed micromirror may be disposed at a special position of the micromirror array 2. For example, the fixed micromirror is disposed at an array edge position of the micromirror array 2, while the rotatable micromirrors are disposed at other positions. For another example, when the micromirror array 2 is rectangular, the fixed micromirror is disposed at a vertex angle position of the array, while the rotatable micromirrors are disposed at other positions.

Whether the micromirror array 2 includes the fixed micromirror and a specific position of the fixed micromirror in the micromirror array are not specifically limited in this embodiment. Unless otherwise specified, the micromirror described below is the rotatable micromirror.

In an example, because the micromirror array 2 includes the rotatable micromirrors, to drive the micromirrors 21 in the micromirror array 2 to rotate, correspondingly, the micromirror chip further includes drive components. The drive components are configured to drive the rotatable micromirrors in the micromirror array 2 to rotate. Therefore, the drive component and the micromirror array are located on a same side of the substrate 1. The drive component is also located on the first surface of the substrate 1 (where the drive component is not shown in the accompanying drawings of this embodiment).

As described above, the micromirror recess is formed on the first surface of the substrate 1. In this case, the drive components are in one-to-one correspondence with the rotatable micromirrors in the micromirror array. The drive component may be disposed in the micromirror recess, and each rotatable micromirror is disposed on a rotatable structure of one drive component. Under the action of the drive signal, the rotatable structure of the drive component rotates, to drive the rotatable micromirror to rotate.

In an example, if the micromirror array 2 includes the fixed micromirror, and the fixed micromirror does not need to rotate, the fixed micromirror does not need to be driven by the drive component. Therefore, the fixed micromirror is directly disposed on the first surface of the substrate 1, or is directly disposed in the micromirror recess on the first surface of the substrate 1, or the fixed micromirror is disposed on the first surface of the substrate 1 through a fastening bracket. An arrangement manner of the fixed micromirror is not specifically limited in this embodiment.

In an example, the drive component that drives the rotatable micromirror to rotate may be an electrostatic drive component, or may be a piezoelectric drive component. This is not limited in this embodiment. Because the solution in this embodiment does not involve the drive component, the drive component is not described in detail below again.

The foregoing describes the features of the micromirror array 2. The following describes features of an electrode that inputs a drive signal to the drive component that drives the rotatable micromirror to rotate.

In an example, to input the drive signal to the drive component that drives the micromirror to rotate, correspondingly, with continued reference to FIG. 1, the micromirror chip includes electrodes 3. The electrode 3 is a pad located on a surface of the substrate 1. Because the micromirror array 2 includes a plurality of rotatable micromirrors, a drive signal needs to be input to each rotatable micromirror through the electrode 3. Therefore, with continued reference to FIG. 1, there are also a plurality of electrodes 3.

In an example, to form a signal loop, each drive component needs two electrodes. The two electrodes may be denoted as a first electrode and a second electrode. Therefore, the electrodes 3 of the micromirror chip include a first electrode 31 and a second electrode 32. One of the first electrode 31 and the second electrode 32 is used as a positive electrode, and the other is used as a negative electrode. For example, the first electrode is used as the negative electrode, and the second electrode is used as the positive electrode. Certainly, alternatively, the first electrode may be used as the positive electrode, and the second electrode may be used as the negative electrode.

In an example, to reduce a quantity of electrodes, all the rotatable micromirrors may share a negative electrode, while the rotatable micromirrors are in one-to-one correspondence with the positive electrodes. Therefore, there may be one first electrode 31, and a quantity of second electrodes 32 is greater than or equal to a quantity of rotatable micromirrors.

In another example, there may be a plurality of first electrodes 31. For example, a quantity of first electrodes 31 may be a, and a quantity of rotatable micromirrors may be b, where a≤b.

In another example, a quantity of second electrodes 32 may be greater than a quantity of rotatable micromirrors. In this way, one rotatable micromirror corresponds to one or more second electrodes 32.

The quantity of first electrodes 31 and the quantity of second electrodes 32 are not specifically limited in this embodiment.

The following describes positions of the first electrode 31 and the second electrode 32 on the substrate 1. Both the first electrode 31 and the second electrode 32 are disposed on the surface of the substrate 1.

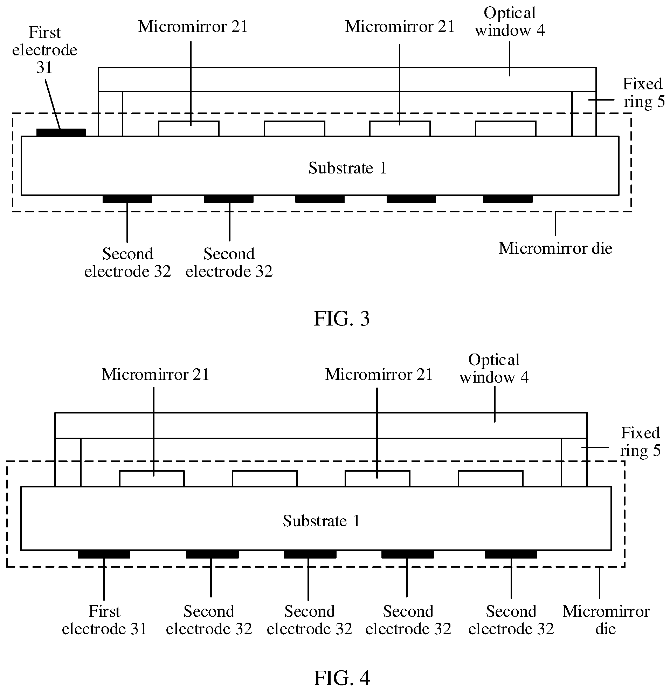

In an example, as shown in FIG. 3, because there are a small quantity of first electrodes 31, the first electrode 31 and the micromirror array 2 may be located on a same side of the substrate 1, for example, both are located on the first surface of the substrate 1. In addition, the first electrode 31 is located in outer space of a fixed ring 5, so that the first electrode 31 is electrically connected to a base plate 100 or an RDL (re-distribution layer) 400 during subsequent packaging. However, because there are a large quantity of second electrodes 32, if the second electrodes 32 and the micromirror array 2 are disposed on a same side, an area of the micromirror chip may be large. Therefore, with continued reference to FIG. 3, the large quantity of second electrodes 32 may be disposed on a second surface of the substrate 1.

The first electrode 31 and the second electrode 32 are arranged based on a layout shown in FIG. 3. During subsequent packaging, the first electrode 31 may be connected to the base plate 100 or the RDL 400 through wire bonding (wire bonding), while the second electrode 32 is connected to the base plate 100 or the RDL 400 through a solder ball (solder ball).

In another example, as shown in FIG. 4, both the first electrode 31 and the second electrode 32 are disposed on a second surface of the substrate 1. In this way, both the first electrode 31 and the second electrode 32 can be located in outer space of the fixed ring 5. Therefore, before the micromirror chip is packaged, it is easier to first seal the micromirror array 2.

The foregoing describes the features of the micromirror die. The following describes sealing of the micromirror array 2. Structures in dashed boxes in FIG. 1, FIG. 3, and FIG. 4 are micromirror dies.

In an example, to first seal the micromirror array 2 before the micromirror die is packaged, correspondingly, with reference to FIG. 4, the micromirror chip further includes the optical window 4 and the fixed ring 5. The fixed ring 5 is fastened onto the first surface of the substrate 1 and encloses the micromirror array 2. In other words, the fixed ring 5 is in a ring shape, and the micromirror array 2 is located in inner space of the fixed ring 5.

Still refer to FIG. 4. The optical window 4 is fastened onto the top of the fixed ring 5, and covers the micromirror array 2, so that the micromirror array 2 is sealed in a sealed space formed by the substrate 1, the fixed ring 5, and the optical window 4.

It should be noted that, as described above, each rotatable micromirror in the micromirror array 2 is driven by the drive component to rotate. Therefore, the drive component configured to drive the micromirror to rotate is also sealed in the sealed space formed by the substrate 1, the fixed ring 5, and the optical window 4.

The electrode 3 needs to be led out through wire bonding, through a pin, or through a solder ball during packaging. Therefore, the electrode 3 is located in the outer space of the fixed ring 5. For example, refer to FIG. 3. In a solution in which the first electrode 31 is located on the first surface of the substrate 1, the first electrode 31 is located in the outer space of the fixed ring 5.

It can be learned that, during packaging of the micromirror chip, because the micromirror array 2 is already sealed, in a packaging process, no small particles fall into an environment in which the micromirror array 2 is located, so that a qualification rate of a packaged micromirror device can be improved, thereby improving a yield rate of the packaged micromirror device.

The following describes features of the optical window 4 and the fixed ring 5.

In an example, to avoid interfering with rotation of the rotatable micromirror, a minimum spacing between the optical window 4 and the first surface of the substrate 1 may be greater than 100 µm, so that the micromirror 21 does not touch the optical window 4 when rotating to a specified maximum rotation angle.

In an example, a material of the optical window 4 is a transparent material, which has a high transmittance and a low reflectivity. For example, an antireflective film may be coated on each of an inner surface and an outer surface of the optical window 4. For example, antireflective films may be coated on the inner surface and the outer surface of the optical window 4. The antireflective film can improve a transmittance in a specific band, for example, improve a transmittance in a band from 1100 nm to 1700 nm.

In an example, because the inner surface of the optical window 4 is fastened onto the top of the fixed ring 5, to facilitate fastening of the optical window 4 and the fixed ring 5, there is no antireflective film at a position at which the inner surface of the optical window 4 is fastened onto the fixed ring 5. For example, when the antireflective film is coated on the inner surface of the optical window 4, a region used for fastening onto the fixed ring 5 is reserved without antireflective film coating. For another example, after the antireflective film is coated on an entire inner surface of the optical window 4, an antireflective film in a region used for fastening onto the fixed ring 5 is removed.

It should be noted that, that the region that is on the inner surface of the optical window 4 and that is used for fastening onto the fixed ring 5 has no antireflective film is a theoretical case. However, during actual processing, due to an error, an antireflective film is coated at some positions in the region.

In an example, the optical window 4 may be in a flat plate shape, and cover the top of the fixed ring 5. The top of the fixed ring 5 is an end facing away from the substrate 1.

In an example, although the reflectivity of the optical window 4 is low, the optical window 4 still has a specific reflectivity. As a result, light that is incident to the optical window 4 is reflected to a detector through the optical window 4, and causes interference to an optical signal received by the detector (where in a theoretical case, the light passes through the optical window 4, is incident to the micromirror 21, and is reflected by the micromirror 21, and reflected light passes through the optical window 4 and enters the detector).

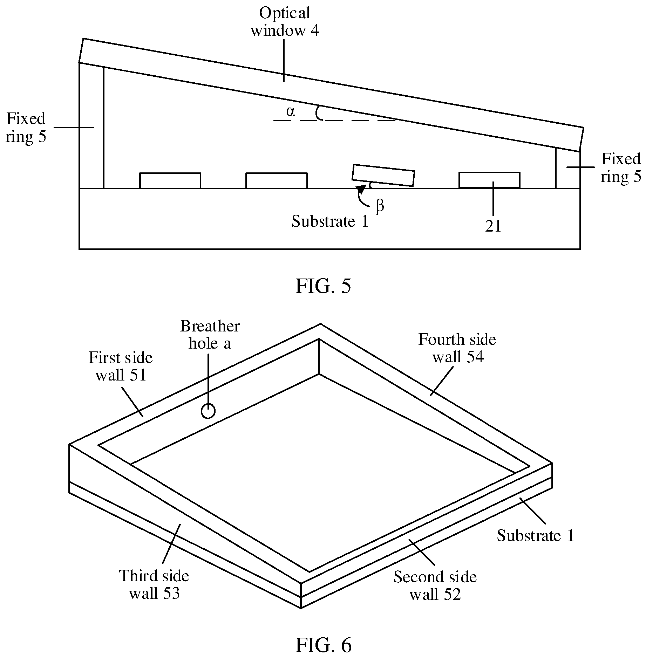

To avoid a case in which the reflected light reflected by the optical window 4 is incident to the detector and causes interference to the optical signal received by the detector, correspondingly, as shown in FIG. 5, the optical window 4 is in the flat plate shape, an included angle α is formed between the optical window 4 and a horizontal plane on which the substrate 1 is located, and the included angle α is greater than a maximum rotation angle β of rotatable micromirrors in the micromirror array 2.

The maximum rotation angle β is a maximum rotation angle of all rotatable micromirrors. For example, maximum rotation angles of all the rotatable micromirrors are the same, that is, β. For another example, maximum rotation angles of all the rotatable micromirrors are different, but β is a largest maximum rotation angle.

In this way, regardless of how many degrees the rotatable micromirror rotates, the optical window 4 is not parallel to the rotatable micromirror. A reflection optical path of the optical window 4 does not fall within a range of a scanning field of view of the rotatable micromirror, provided that the optical window 4 is not parallel to the rotatable micromirror. The detector is disposed within the range of the scanning field of view of the rotatable micromirror. Therefore, the detector can be only in the scanning field of view of the rotatable micromirror, instead of being on the reflection optical path of the optical window 4, so that light reflected by the optical window 4 does not enter the detector. In this way, even if the optical window 4 has a specific reflectivity, the light reflected by the optical window 4 does not cause interference to an optical signal received by the detector.

It should be noted that in some solutions, light reflected by the micromirror is coupled to a coupler, enters an optical fiber through the coupler, and then is incident to the detector (or an output end) through the optical fiber. In this case, to prevent light reflected by the optical window 4 from entering the detector, correspondingly, the light reflected by the optical window 4 only needs to be prevented from entering the coupler, and the light does not enter the detector through the optical fiber, provided that the light does not enter the coupler. Alternatively, light reflected by the optical window 4 enters the coupler at a large angle of incidence (that is, an included angle between the light and a normal of the coupler), to reduce optical coupling efficiency. The light reflected by the optical window 4 is coupled to the optical fiber at low efficiency. Therefore, the light entering the detector is also weak, and may be ignored.

In an example, inclination of the optical window 4 may be set based on a height of the fixed ring 5. For example, FIG. 6 is a diagram in which the fixed ring 5 is fastened onto the first surface of the substrate 1. Refer to FIG. 6. The fixed ring 5 includes a first side wall 51, a second side wall 52, a third side wall 53, and a fourth side wall 54. The first side wall 51 and the second side wall 52 are opposite, and a height of the first side wall 51 is greater than a height of the second side wall 52. The third side wall 53 and the fourth side wall 54 are opposite, and an included angle between a plane on which the tops of the third side wall 53 and the fourth side wall 54 are located and a plane on which the substrate 1 is located is α. In this way, the optical window 4 covers the top of the fixed ring 5, and an included angle between the optical window 4 and the substrate 1 is also α.

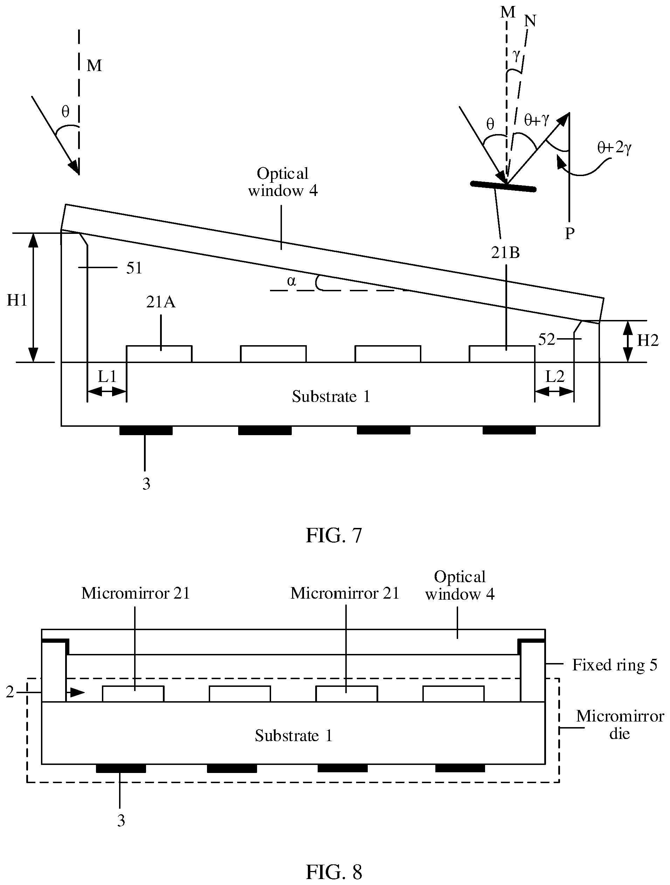

In an example, refer to FIG. 6. The height of the fixed ring 5 and a spacing between the fixed ring 5 and a micromirror at an array edge affect a scanning field of view of the micromirror chip. The scanning field of view of the micromirror chip is an included angle between maximum incident light and maximum emergent light. Therefore, to avoid affecting the scanning field of view of the micromirror chip, correspondingly, with reference to FIG. 7, a size of the fixed ring 5 satisfies the following relationship:$L 1 / H 1 \geq tan \left(θ\right) , and L 2 / H 2 \geq tan \left(θ+2γ\right) .$

Refer to FIG. 7. L1 is a minimum spacing between the fixed ring 5 and a first micromirror 21A that is close to a direction of incident light and that is located at an array edge of the micromirror array 2, and H1 is a height of the fixed ring 5 near the first micromirror 21A. The first micromirror 21A may be a fixed micromirror, or may be a rotatable micromirror.

Refer to FIG. 6 and FIG. 7. Generally, light is parallel to the third side wall 53, and is incident to the micromirror chip from an upper left corner of the first side wall 51 or from an upper right corner of the second side wall 52. For example, as shown in FIG. 7, the light is incident to the micromirror chip from the upper left corner of the first side wall 51. Refer to FIG. 7. L1 is a spacing between an inner surface of the first side wall 51 and a side that is of the first micromirror 21A and that is close to the first side wall 51, and H1 is the height of the first side wall 51.

In the formula, θ is a maximum included angle between incident light and a normal of the horizontal plane on which the substrate 1 is located.

Therefore, with reference to FIG. 7, when the size of the fixed ring 5 satisfies: L1/H1≥tan(θ), light at any angle of incidence can be incident to any micromirror 21 in the micromirror array 2.

Still refer to FIG. 7. L2 is a minimum spacing between the fixed ring 5 and a second micromirror 21B that is close to a direction of emergent light and that is located at an array edge of the micromirror array 2, and H2 is a height of the fixed ring 5 near the second micromirror 21B. For example, refer to FIG. 7. L2 is a spacing between an inner surface of the second side wall 52 and a side that is of the second micromirror 21B and that is close to the second side wall 52, and H2 is the height of the second side wall 52.

In FIG. 7, a straight line M represents the normal of the horizontal plane on which the substrate 1 is located, a straight line N represents a normal of the second micromirror 21B in a state in which the second micromirror 21B is rotated to a maximum rotation angle γ, and a plane P represents a plane on which the inner surface of the second side wall 52 is located.

γ is the maximum rotation angle of the second micromirror 21B, and is less than or equal to β, and β is a largest maximum rotation angle of all the rotatable micromirrors.

Refer to FIG. 7. When the second micromirror 21B rotates to an angle of γ, a normal perpendicular to the second micromirror 21B also rotates to an angle of γ. Therefore, as shown in FIG. 7, an included angle between the straight line M and the straight line N is γ. The straight line M may also be considered as a normal of the second micromirror 21B when the second micromirror 21B rotates by 0 degrees (that is, is parallel to the substrate).

Therefore, refer to FIG. 7. When the second micromirror 21B rotates to the maximum rotation angle γ, an included angle between the inner surface of the second side wall 52 and light reflected by the second micromirror 21B at the current rotation angle is θ+2γ.

Therefore, refer to FIG. 7. When the size of the fixed ring 5 satisfies: L2/H2≥tan(θ+2γ), light reflected by any micromirror can be emitted from the micromirror chip.

In an example, if the optical window 4 is parallel to the substrate 1, H1 is equal to H2. If the optical window 4 is inclined relative to the substrate 1, the height H1 of the first side wall 51 is greater than the height H2 of the second side wall 52, and a difference between H1 and H2 is a product of L3 and tanα. L3 is a spacing between the inner surface of the first side wall 51 and the inner surface of the second side wall 52.

Therefore, when the size of the fixed ring 5 satisfies the relationship shown in the foregoing formula, the fixed ring 5 does not interfere with the scanning field of view of the micromirror chip.

It should be noted that the first micromirror 21A may be a rotatable micromirror, or may be a non-rotatable fixed micromirror, and the second micromirror 21B may also be a rotatable micromirror, or may be a non-rotatable fixed micromirror. If the second micromirror 21B is the non-rotatable fixed micromirror, the maximum rotation angle γ of the second micromirror 21B is 0 degrees.

It should be noted that, for values of H1 and H2, a height change caused by gluing or bonding between the optical window 4 and the fixed ring 5 and a height change caused by gluing or bonding between the fixed ring 5 and the substrate 1 need to be considered.

In an example, as shown in FIG. 8, a first recess is formed on the inner surface of the optical window 4 at a position close to an edge, and the top of the fixed ring 5 is fastened in the first recess.

As shown in FIG. 8, the first recess may be an L-shaped recess, and the recess is located on the inner surface of the optical window 4 and at the edge. In this way, each of two side walls of the recess is in a fastening relationship with the fixed ring 5. Therefore, a fastening area (for example, a bonding area) is increased, thereby enhancing fastening strength between the fixed ring 5 and the optical window 4.

In addition, the recess of the optical window 4 snap-fits with the fixed ring 5. Therefore, before the optical window 4 is fastened onto the fixed ring 5, the optical window 4 is pre-positioned, so that the optical window 4 is less likely to fall off from the top of the fixed ring 5. For example, for an inclined optical window 4, before the optical window 4 is fastened, the optical window 4 is pre-positioned at the top of the fixed ring 5, to prevent the optical window 4 from sliding from the top of the fixed ring 5, or avoid slippage between the optical window 4 and the fixed ring 5.

In another example, the first recess may alternatively be a groove. For example, the groove is formed on the inner surface of the optical window 4 at the position close to the edge, and the top of the fixed ring 5 is fastened in the groove. In this way, the top of the fixed ring 5 is in a fastening relationship with a groove bottom of the groove, and a side wall of the fixed ring 5 is in a fastening relationship with the groove wall of the groove, thereby enhancing fastening strength between the fixed ring 5 and the optical window 4. That the top of the fixed ring 5 is located in the groove means that the top of the fixed ring 5 snap-fits into the groove. In this way, before the optical window 4 is fastened onto the fixed ring 5, the optical window 4 is pre-positioned on the top of the fixed ring 5, so that the optical window 4 is less likely to slide from the top of the fixed ring 5.

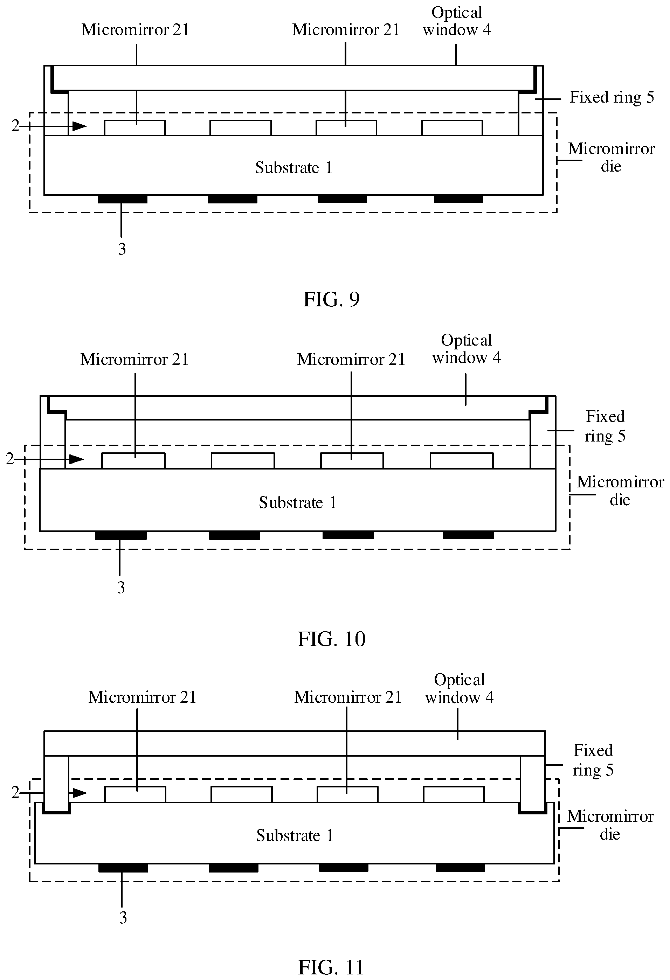

In another example, as shown in FIG. 9, a second recess is formed on an inner surface of the fixed ring 5 at a top position, and the inner surface of the optical window 4 is fastened in the second recess at a position close to an edge. As shown in FIG. 9, the second recess is an L-shaped recess.

The second recess of the fixed ring 5 enhances fastening strength between the optical window 4 and the fixed ring 5, and achieves a pre-positioning function to limit the optical window 4, so as to prevent the optical window 4 from sliding from the top of the fixed ring 5, or avoid slippage between the optical window 4 and the fixed ring 5 during fastening.

In another example, as shown in FIG. 10, a recess is formed on each of the optical window 4 and the fixed ring 5. For example, a first recess is formed on the optical window 4, a second recess is formed on the fixed ring 5, the first recess of the optical window 4 matches the second recess of the fixed ring 5, and the first recess of the optical window 4 snap-fits into the second recess of the fixed ring 5. The first recess of the optical window 4 matches the second recess of the fixed ring 5, so that not only a function of limiting the optical window 4 is achieved, but also a fastening area (for example, a bonding area) of the optical window 4 and the fixed ring 5 can be further increased, thereby improving fastening strength.

It should be noted that, in FIG. 8 to FIG. 10, black fillings at positions at which the optical window 4 is connected to the fixed ring 5 represent fastening regions of the optical window 4 and the fixed ring 5. For example, a black region represents a gluing region or a bonding region.

In an example, a material of the fixed ring 5 may be glue. In this case, the optical window 4 is bonded and fastened onto the substrate 1 through the glue, and the glue is cured to form the fixed ring 5.

In another example, a material of the fixed ring 5 may alternatively be a silicon material, glass, fused quartz, or a metal material. The fixed ring 5 is bonded and fastened onto the substrate 1 through glue, or the fixed ring 5 is bonded and fastened onto the substrate 1 through a bonding process. The fixed ring 5 may be bonded and fastened onto the optical window 4 through glue or a bonding process.

The material of the fixed ring 5 is not specifically limited in this embodiment. For example, the material of the fixed ring 5 may be selected as a material whose coefficient of thermal expansion is between a coefficient of thermal expansion of the optical window 4 and a coefficient of thermal expansion of the substrate 1. In this way, thermal stress of the micromirror chip can be reduced, so that the micromirror chip is less likely to be deformed and is less likely to be cracked under a large temperature difference.

In an example, to enhance fastening between the fixed ring 5 and the substrate 1, correspondingly, as shown in FIG. 11, a groove may be formed at a position at which the first surface of the substrate 1 is fastened onto the fixed ring 5, and the bottom of the fixed ring 5 may be fastened in the groove. In FIG. 11, black fillings at positions at which the fixed ring 5 is connected to the substrate 1 represent fastening regions of the fixed ring 5 and the substrate 1. For example, a black region represents a gluing region or a bonding region.

Groove walls around the groove and a groove bottom of the groove are each in a fastening relationship with the fixed ring 5. Therefore, compared with a solution in which the fixed ring 5 is directly fastened onto the surface of the substrate 1, the solution in which the groove is formed can clearly increase a contact area between the substrate 1 and the fixed ring 5, thereby enhancing adhesion (for example, glue adhesion) between the substrate 1 and the fixed ring 5, and enhancing fastening strength between the substrate 1 and the fixed ring 5.

In an example, the groove on the first surface of the substrate 1 may be replaced with an L-shaped recess. The L-shaped recess faces the outer space of the fixed ring 5, and the bottom of a ring wall of the fixed ring 5 is fastened in the L-shaped recess.

In an example, roughness at the position at which the first surface of the substrate 1 is fastened onto the fixed ring 5 may be greater than roughness at another position. When the fixed ring 5 is fastened onto the substrate 1 at the position with large roughness, adhesion between the substrate 1 and the fixed ring 5 can be enhanced based on the large roughness, thereby enhancing fastening strength between the substrate 1 and the fixed ring 5.

A manner of improving the roughness may be as follows: At a position of the first surface of the substrate 1 that corresponds to a mounting region of the fixed ring 5, a plurality of recesses are etched, so that an inner surface of the region is not flat, thereby increasing surface roughness of the region. Alternatively, a film may be coated on the first surface of the substrate 1 that corresponds to a surface of a mounting region of the fixed ring 5, thereby increasing roughness in the region through a film layer.

Once the fastening strength between the substrate 1 and the fixed ring 5 is enhanced, bonding strength between the substrate 1 and the fixed ring 5 is also enhanced, and airtightness of the inner space of the fixed ring 5 is also enhanced.

In an example, a process of etching the groove or the recess on the first surface of the substrate 1 may be performed during etching a mounting recess of the micromirror. For example, when the mounting recess of the micromirror is formed on the first surface of the substrate 1, the groove and/or the recess may be formed in the mounting region of the fixed ring 5 as well.

In an example, the ring wall of the fixed ring 5 may be a trapezoidal column, and an area of the top of the fixed ring 5 fastened onto the optical window 4 is smaller than an area of the bottom of the fixed ring 5 fastened onto the substrate 1. In this way, strength of the ring wall of the fixed ring 5 can be increased. Ring walls of the fixed ring 5 are, for example, the first side wall 51, the second side wall 52, the third side wall 53, and the fourth side wall 54 shown in FIG. 6.

In another example, refer to FIG. 7. A chamfer is formed on the inner surface that is at the top of the ring wall of the fixed ring 5 and that faces the inner space of the ring. For example, a chamfer is formed on an inner surface of the top of the first side wall 51 of the fixed ring 5, and a chamfer is formed on an inner surface of the top of the second side wall 52. The chamfer can provide clearance for incident light and emergent light. As shown in FIG. 7, the chamfer means cutting a right-angle edge that connects the top of the first side wall 51 and the inner surface into an oblique surface.

In an example, to avoid excessively high atmospheric pressure in the inner space of the fixed ring 5 in a high-temperature process during packaging, correspondingly, with reference to FIG. 6, a breather hole a may be formed in the fixed ring 5. For example, the breather hole a may be formed in any side wall of the fixed ring 5. The breather hole a is in communication with the inner space of fixed ring 5, so that excessively high atmospheric pressure in an environment in which the micromirror array 2 is located can be avoided in the high-temperature process.

In another example, the breather hole a may also be formed in the optical window 4.

In an example, to avoid affecting airtightness of the inner space of the ring, correspondingly, after the high-temperature process ends, the breather hole a may be sealed. For example, welding the micromirror chip and the base plate is a high-temperature process. Therefore, after high-temperature welding of the micromirror chip is completed, the breather hole a may be sealed by using a medium.

In another example, in an application, the micromirror chip is disposed in a housing with good airtightness, and the breather hole a may not need to be sealed.

In an example, in a packaging process of the micromirror chip, after an exhausting operation is completed through the breather hole a, the breather hole a may also be sealed. For example, the breather hole a is sealed through dispensing with cured glue.

To avoid a case in which the glue flows to the inner space of the fixed ring 5 during dispensing in the breather hole a, affecting rotation of the rotatable micromirror, correspondingly, the breather hole a on the optical window 4 is as close as possible to the fixed ring 5. For example, a part of a vertical projection of the breather hole a on the substrate 1 falls in the inner space of the fixed ring 5, and the other part falls on the fixed ring 5. That is, the breather hole a on the optical window 4 is not only formed in the optical window 4, but also formed in the fixed ring 5. A part of the breather hole a in the fixed ring 5 may or may not extend through the fixed ring 5 in a height direction.

In this way, when the breather hole a is sealed through dispensing, glue may adhere to the fixed ring 5, and almost does not fall into the inner space of the fixed ring 5.

In another example, for a solution in which the breather hole a is formed on the optical window 4, a hole diameter of the breather hole a is small. In this way, when the breather hole a is sealed through dispensing, glue adheres to a hole wall of the breather hole a, and therefore, the glue is less likely to flow into the inner space of the fixed ring 5.

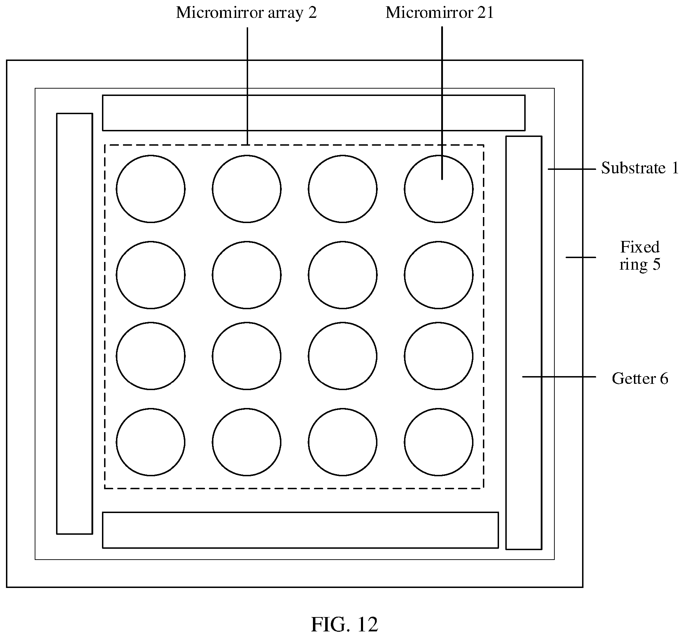

In an example, as shown in FIG. 12, the micromirror chip may further include a getter 6. The getter 6 is located on the first surface of the substrate 1, and is located in the inner space of the fixed ring 5. For example, refer to FIG. 12. The getter 6 is located between the fixed ring 5 and micromirrors at the array edge of the micromirror array 2.

The getter 6 is configured to absorb gas and moisture in a sealed space enclosed by the substrate 1, the fixed ring 5, and the optical window 4, and may be formed by coating a getter film layer on the first surface of the substrate 1.

In an example, the inner surface of the fixed ring 5 may be coated with a getter film layer, and the getter film layer is configured to absorb gas and moisture in the sealed space enclosed by the substrate 1, the fixed ring 5, and the optical window 4. The inner surface of the fixed ring 5 is a surface facing the inner space of the ring.

In an example, the getter 6 and the getter film layer on the inner surface of the fixed ring 5 may both exist in the micromirror chip, or one of the getter 6 and the getter film layer may exist in the micromirror chip.

The getter 6 on the first surface of the substrate 1 is also a getter film layer, and may be made of a same material as the getter film layer on the inner surface of the fixed ring 5.

In an example, an outer surface of the fixed ring 5 may be coated with a light shielding film layer, to avoid interference from stray light in an environment. The outer surface of the fixed ring 5 is a surface facing the outer space of the ring. In another example, a material of the fixed ring 5 may alternatively be a material with a low transmittance. In this way, stray light in an environment can also be prevented from entering the inner space of the fixed ring 5 and causing interference.

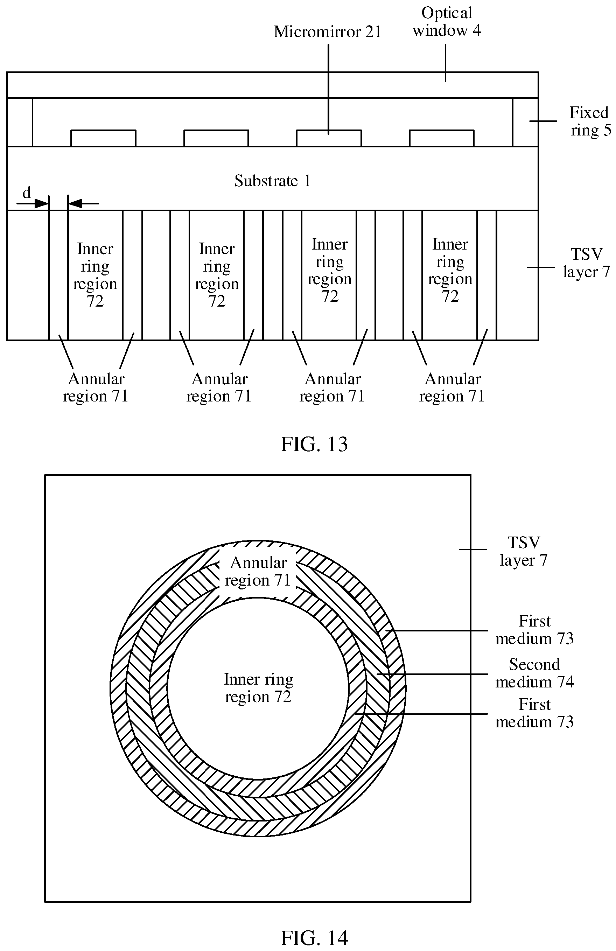

In an example, FIG. 13 is a structural diagram of a micromirror chip. Refer to FIG. 13. The micromirror chip may further include an electrode lead-out layer. The electrode lead-out layer is located on the second side of the substrate 1, electrodes are disposed on the electrode lead-out layer, and the electrodes on the electrode lead-out layer are electrically connected to the electrodes on the second side of the substrate 1.

Refer to FIG. 13. The electrode lead-out layer is a through-silicon via (through-silicon via, TSV) layer 7, and annular regions 71 extending in a thickness direction are formed on the TSV layer 7. As shown in FIG. 13 and with reference to FIG. 14, a through hole that extends through the TSV layer 7 in a thickness direction is located between an inner ring wall and an outer ring wall of the annular region 71. The through hole is filled with a medium, for example, filled with a first medium 73, or filled with the first medium 73 and a second medium 74.

A quantity of annular regions 71 is equal to a quantity of electrodes 3 on the second surface of the substrate 1, and the electrodes 3 on the second surface of the substrate 1 are connected to inner ring regions 72 of the annular regions 71 in a one-to-one manner.

A material of the TSV layer 7 is silicon and is conductive. Therefore, the inner ring region 72 enclosed by an inner ring of the annular region 71 may be used as an electrode on the TSV layer 7, and is electrically connected to the electrode 3 on the second surface of the substrate 1, or the inner ring region 72 may be referred to as a conductive path, and is connected to the electrode 3 on the second surface of the substrate 1.

In an example, the electrodes 3 on the second surface of the substrate 1 may all be drive electrodes configured to drive the rotatable micromirrors to rotate. Both the first electrode 31 and the second electrode 32 are drive electrodes, one of the first electrode 31 and the second electrode 32 is a positive drive electrode, and the other is a negative drive electrode.

In an example, all the electrodes 3 on the second surface of the substrate 1 are second electrodes 32, and each second electrode 32 is connected to one inner ring region 72. For another example, the electrodes 3 on the second surface of the substrate 1 include at least one first electrode 31 and all second electrodes 32. In this case, each of the at least one first electrode 31 is connected to one inner ring region 72, and each of the second electrodes 32 is connected to one inner ring region 72. For example, if the electrodes 3 on the second surface of the substrate 1 include one first electrode 31 and three second electrodes 32, and there are four inner ring regions 72, one inner ring region 72 is connected to the first electrode 31, and three inner ring regions 72 are connected to the three second electrodes 32 in a one-to-one manner.

In an example, the electrodes 3 on the second surface of the substrate 1 include not only drive electrodes (that is, the first electrode 31 and the second electrode 32) but also a test electrode. The test electrode is configured to test conductivity between the TSV layer 7 and a connected base plate 100 or RDL 400.

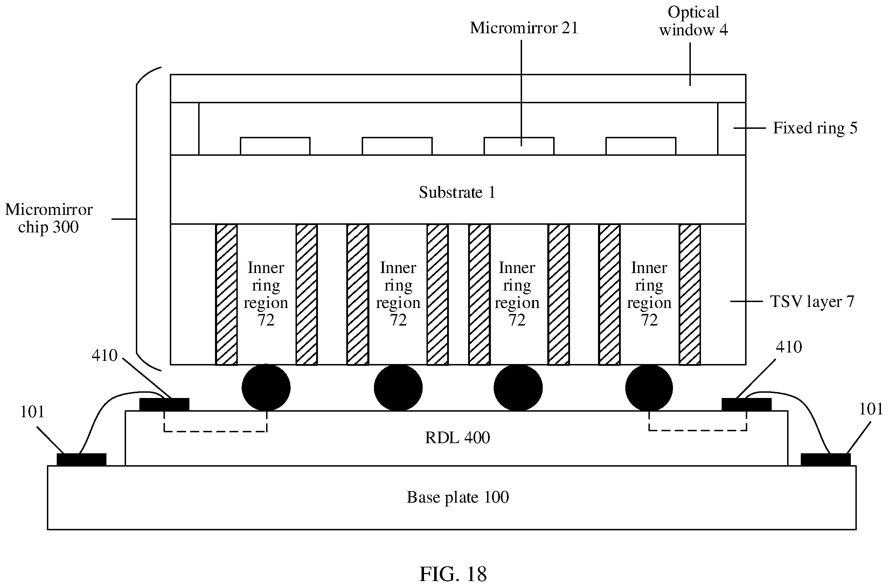

As shown in FIG. 18, an example in which the TSV layer 7 is connected to the RDL 400 is used, and each inner ring region 72 of the TSV layer 7 is connected to the RDL 400. In this case, testing connectivity between the TSV layer 7 and the connected RDL 400 means testing connectivity between the inner ring region 72 and the RDL 400. For example, if the inner ring region 72 is connected to the RDL 400 through a solder ball, conductivity between the solder ball and the inner ring region 72 and conductivity between the solder ball and the RDL 400 are tested.

It should be noted that, not conductivity between all inner ring regions 72 and the RDL 400 is tested, because a part of the inner ring regions 72 is also connected to the drive electrode (for example, the second electrode 32). For example, there are eight inner ring regions 72. Five inner ring regions 72 are connected to the drive electrodes (for example, the second electrodes 32), to input drive signals to the rotatable micromirrors, and three inner ring regions 72 are connected to the test electrode (for example, the three inner ring regions 72 are connected in series on a test link). In this case, when connectivity is tested, connectivity between the inner ring regions 72 located on the test link and the RDL 400 is tested.

In an example, there are one or more test electrodes (for example, a quantity of test electrodes is an odd number). For example, all test electrodes are positive electrodes. To form the test link, one of the drive electrodes may be used as a negative electrode. For example, one of the foregoing first electrodes may be used as the negative electrode on the test link. Alternatively, the other end of each test link is grounded.

In an example, there are two or more test electrodes (for example, a quantity of test electrodes is an even number). For example, in each pair of test electrodes, one test electrode is a positive electrode, and the other test electrode is used as a negative electrode.

Regardless of whether the quantity of test electrodes is an odd number or an even number, a positive electrode and a negative electrode on each test link need to be connected, or a negative electrode on each test link needs to be grounded, to form a closed short circuit. Then, in the test, a resistance meter is used to test resistance in the closed short circuit. If the resistance is large, it indicates that conductivity of at least one connection position on the test link is poor. If the resistance is small, it indicates that conductivity of all connection positions on the test link is good.

It should be noted that a positive electrode and a negative electrode on a drive link that are configured to drive the rotatable micromirror to rotate are respectively connected to a positive electrode and a negative electrode of a driver chip, so that the driver chip drives the rotatable micromirror to rotate. Alternatively, a positive electrode on a drive link is connected to a positive electrode of a driver chip, and a negative electrode on the drive link and a negative electrode of the driver chip are connected to a common ground.

Regardless of whether electrodes 3 on a lower surface of the substrate 1 are all drive electrodes or include the drive electrode and the test electrode, all the electrodes 3 on the lower surface (that is, the second surface) of the substrate 1 are led to the bottoms of all inner ring regions 72 through all the inner ring regions 72 on the TSV layer 7, and the bottom of the inner ring region 72 is a position away from the substrate 1.

Still refer to FIG. 14. The annular region 71 is filled with the insulating first medium 73, to implement electrical isolation between two adjacent inner ring regions 72, where the first medium 73 may be silicon oxide. FIG. 14 is a diagram of a local top view near an annular region 71 in FIG. 13.

In an example, refer to FIG. 13. If an annular width d of the annular region 71 is large, silicon oxide is deposited in the annular region 71. A growth period of silicon oxide is long, prolonging a manufacturing period of the micromirror chip. In addition, the first medium 73 is silicon oxide, a material of the TSV layer 7 is monocrystalline silicon, and a difference between coefficients of thermal expansion of silicon oxide and silicon is large. In this case, thermal stress is large, and the micromirror chip is likely to be deformed under a temperature change.

In this case, when the annular width d of the annular region 71 is large, the first medium 73 and the second medium 74 may be filled in the annular region 71, a coefficient of thermal expansion of the second medium 74 is between a coefficient of thermal expansion of the first medium 73 and a coefficient of thermal expansion of a material in the inner ring region 72. For example, refer to FIG. 14. The inner ring wall and the outer ring wall of the annular region 71 are each covered with the first medium 73. The second medium 74 is filled between the first medium 73 on the inner ring wall and the first medium 73 on the outer ring wall. In this way, thermal stress of the TSV layer 7 can be reduced.

The second medium 74 may be polycrystalline silicon.

In this way, a material of the TSV layer 7 is monocrystalline silicon, a material of the second medium 74 is polycrystalline silicon, and both the TSV layer 7 and the second medium 74 are silicon materials. In this case, coefficients of thermal expansion of the TSV layer 7 and the second medium 74 are close, and thermal stress between the TSV layer 7 and the second medium 74 is small. Therefore, the micromirror chip is less likely to be deformed under a temperature change.

In an example, because the material of the substrate 1 is silicon, and the material of the TSV layer 7 is also silicon, with reference to FIG. 13, during processing of the micromirror die, the TSV layer 7 and the substrate 1 grow together to form an overall substrate of the micromirror die. At the bottom of the overall substrate, a plurality of annular regions 71 are etched in a thickness direction, but the annular regions 71 do not extend through the overall substrate in a thickness direction. In this case, the overall substrate is divided into the substrate 1 without the annular regions 71 and the TSV layer 7 with the annular regions 71. Therefore, the TSV layer 7 is a part of the micromirror die.

The micromirror die includes the TSV layer 7, and the TSV layer 7 has a specific thickness. Therefore, the TSV layer 7 can increase an overall thickness of the micromirror die. Once the overall thickness of the micromirror die is large, rigidity of the micromirror die is high, and deformation is less likely to occur in a packaging process.

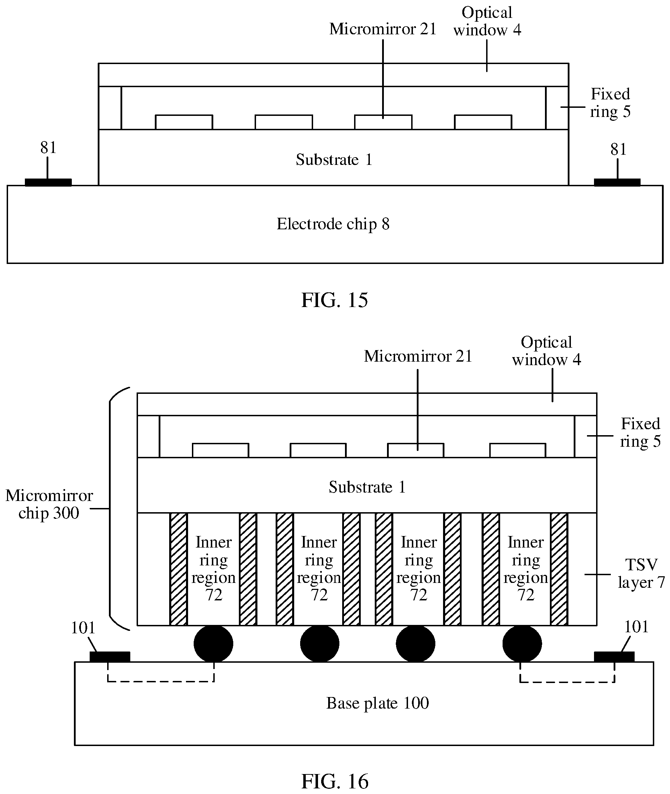

In another example, the electrode lead-out layer may be a chip (denoted as an electrode chip 8) instead of the TSV layer 7. As shown in FIG. 15, the electrode lead-out layer is the electrode chip 8. An area of the electrode chip 8 is larger than an area of the substrate 1. An electrode is disposed at a position that extends out of the substrate 1 and that is on an upper surface of the electrode chip 8, and the upper surface of the electrode chip 8 is a surface facing the second side of the substrate 1. The electrode 81 on the upper surface of the electrode chip 8 is electrically connected to the electrode 3 on the second side of the substrate 1 through a routing trace inside the electrode chip 8.

In another example, the electrode lead-out layer may alternatively include the TSV layer 7 and an electrode chip 8. In this solution, the inner ring region 72 on the TSV layer 7 is electrically connected to an electrode of the electrode chip 8 through a routing trace inside the electrode chip 8.

It should be noted that a sealing process of the micromirror array 2, that is, a fastening process of the fixed ring 5 and the optical window 4, may be considered as a preprocessing process before packaging of the micromirror die, or may be considered as a first step of packaging of the micromirror die. Regardless of which step is considered, the micromirror array 2 is sealed before the micromirror die is packaged on the base plate.

In this embodiment of the present disclosure, during packaging of the micromirror chip, because the micromirror array 2 is first sealed in the sealed space formed by the substrate, the fixed ring, and the optical window, in a subsequent packaging process, no small particles fall into the environment in which the micromirror array 2 is located, so that the qualification rate of the packaged micromirror device can be improved, thereby improving the yield rate of the packaged micromirror device.

An embodiment further provides a micromirror device. The micromirror device may be used in an optical cross connect (optical cross connect, OXC), a wavelength selective switch (wavelength selective switch, WSS), or the like.

As shown in FIG. 16, the micromirror device includes a base plate 100, a driver chip 200, and the foregoing micromirror chip 300. An example in which the micromirror chip 300 includes the TSV layer 7 is used.

The driver chip 200 is electrically connected to the micromirror chip 300, to transmit a drive signal to an electrode 3 of a micromirror die, to drive the rotatable micromirrors in the micromirror array 2 to rotate.

In an example, refer to FIG. 16. The micromirror chip 300 is located on the base plate 100. For example, the micromirror chip 300 is fastened onto the base plate 100 through a gluing, bonding, or welding process.

Still refer to FIG. 16. The base plate 100 has a line, and electrodes may be further disposed on a surface of the base plate 100. The inner ring region 72 of the micromirror chip 300 is electrically connected to the base plate 100 through a solder ball (solder ball), and the solder ball is electrically connected to the electrode 101 on the surface of the base plate 100 through a routing trace inside the base plate 100. The electrode 101 on the surface of the base plate 100 is configured to be electrically connected to another device, for example, electrically connected to the driver chip 200.

The solder ball described above and a solder ball mentioned below may be replaced by stud bumps (stud bumps), solder bumps (solder bumps), and the like.

In this way, an electrode on the second surface (that is, the lower surface) of the substrate 1 is connected to the base plate 100 through the TSV layer 7. If there is also an electrode on the first surface (that is, the upper surface) of the substrate 1, the electrode on the upper surface of the substrate 1 may be connected to the base plate 100 through wire bonding.

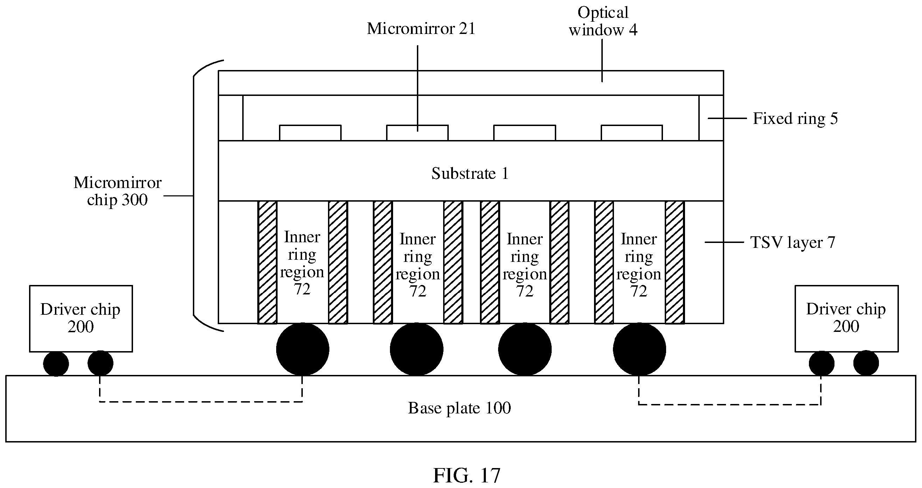

As shown in FIG. 17, the driver chip 200 may alternatively be disposed on the surface of the base plate 100. The driver chip 200 is connected to the base plate 100 through a solder ball. In this way, the driver chip 200 is electrically connected to the micromirror chip 300 through a routing trace inside the base plate 100.

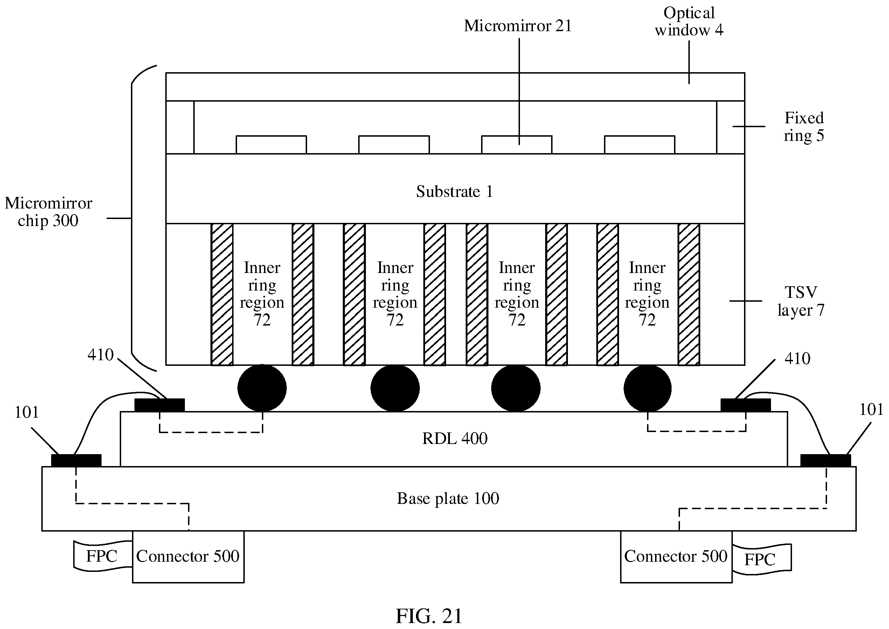

In another example, in a solution in which the driver chip 200 is not on the base plate 100, the driver chip 200 may be electrically connected to the micromirror chip 300 through a connector and a flexible printed circuit (flexible printed circuit, FPC). Refer to FIG. 21.

In another example, as shown in FIG. 18, the micromirror device may further include a re-distribution layer (re-distribution layer, RDL) 400, the RDL 400 is located on the surface of the base plate 100, and the micromirror chip 300 is located on an upper surface of the RDL 400. The upper surface of the RDL 400 is a surface facing away from the base plate 100.

The micromirror chip 300 is connected to the RDL 400 through a solder ball (solder ball), electrodes are disposed on the upper surface of the RDL 400, and an electrode 410 on the RDL 400 is connected to an electrode 101 on the base plate 100 through wire bonding (wire bonding).

In this way, an electrode on the second surface (that is, the lower surface) of the substrate 1 is connected to the RDL 400 through the TSV layer 7. If there is also an electrode on the first surface (that is, the upper surface) of the substrate 1, the electrode on the upper surface of the substrate 1 may be connected to the RDL 400 through wire bonding.

In an example, a material of the RDL 400 is silicon. Even if an area of the RDL 400 is large, a surface of the RDL 400 can be flat. A material of the base plate 100 is ceramic. When an area of the base plate 100 is large, the surface of the base plate 100 is difficult to be flat. Therefore, the micromirror chip 300 is directly fastened onto the surface of the RDL 400, instead of being directly fastened onto the surface of the base plate 100. This can enhance a fixed connection between the micromirror chip 300 and the RDL 400, and reduce packaging stress.

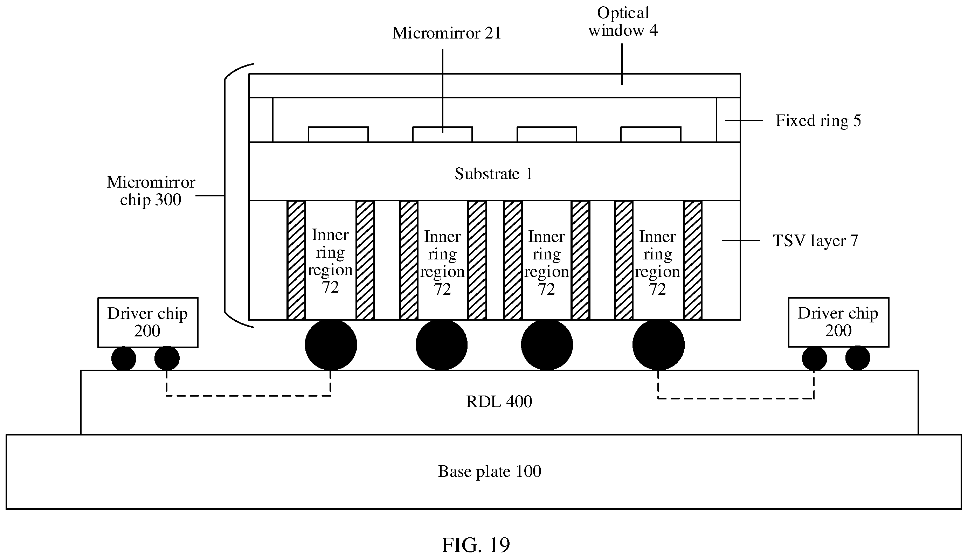

In an example, the driver chip 200 may be fastened onto the upper surface of the RDL 400. As shown in FIG. 19, both the driver chip 200 and the micromirror chip 300 are located on the upper surface of the RDL 400, and the driver chip 200 is electrically connected to the micromirror chip 300 through a routing trace inside the RDL 400.

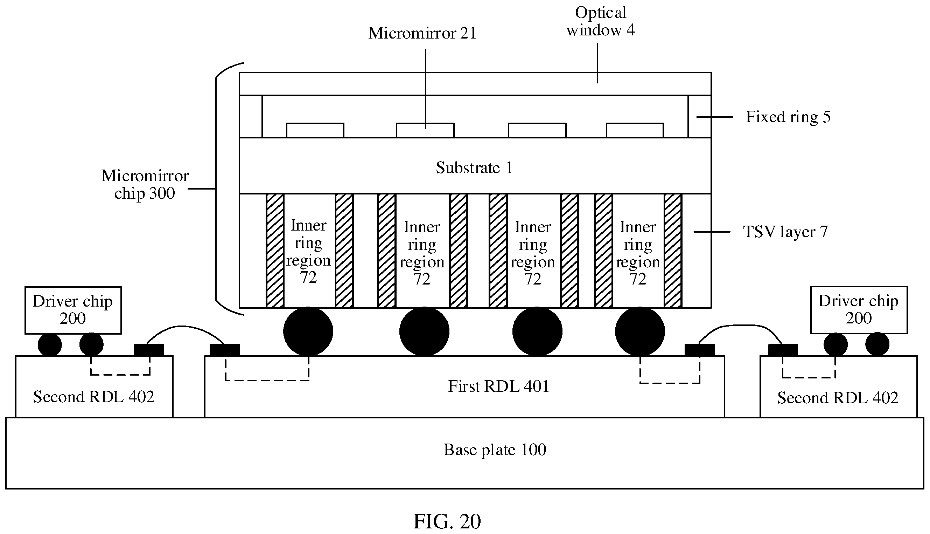

In another example, as shown in FIG. 20, RDLs 400 may include a first RDL 401 and a second RDL 402. Both the first RDL 401 and the second RDL 402 are fixedly located on the surface of the base plate 100. The micromirror device 300 is located on an upper surface of the first RDL 401, and the driver chip 200 is located on an upper surface of the second RDL 402. For example, the driver chip 200 is in one-to-one correspondence with the second RDL 402. The first RDL 401 is connected to the second RDL 402 through wire bonding.

In the solution shown in FIG. 20, the driver chip 200 is separately welded on one RDL. In this way, even if an error occurs in a process of welding one driver chip 200 on the second RDL 402, the micromirror chip 300 and another driver chip are not affected, so that a yield rate loss can be reduced, and a yield rate of the micromirror device can be improved.

In the solution shown in FIG. 19, because the micromirror chip 300 and all driver chips 200 are disposed on the RDL 400, once an error occurs in a process in which one driver chip 200 is welded on the RDL, an entire micromirror device may be scrapped.

It should be noted that, in a solution in which the micromirror chip includes the RDL 400, the driver chip 200 may not be located on the upper surface of the RDL 400, but may be located on the surface of the base plate 100. Alternatively, the driver chip 200 is neither on the surface of the RDL 400 nor on the surface of the base plate 100, but is electrically connected to the micromirror chip 300 through a connector 500 and the FPC. In this solution, the connector 500 may be welded on the surface (for example, the upper surface or the lower surface) of the RDL 400.

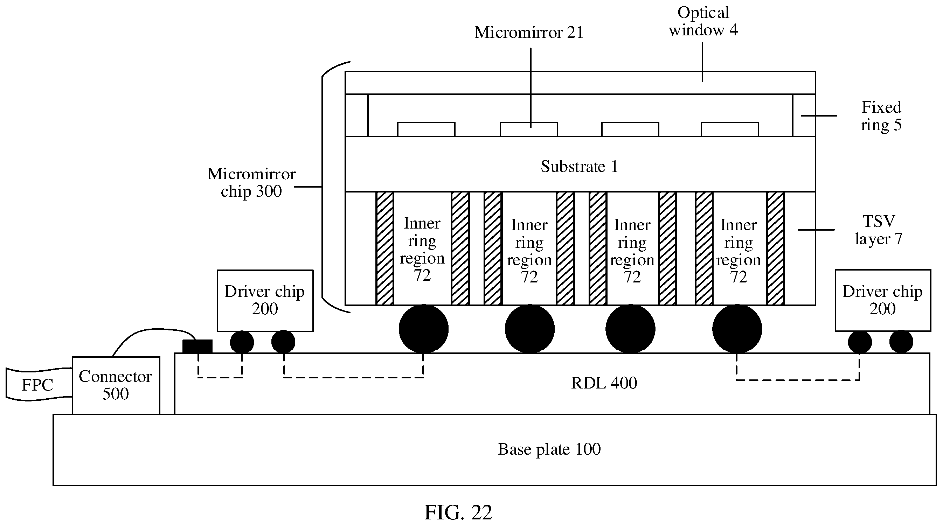

As shown in FIG. 21 and FIG. 22, the micromirror device further includes the connector 500. The connector 500 may be located on an upper surface of the base plate 100, or may be located on a lower surface of the base plate 100. Refer to FIG. 21. The connector 500 may be configured to implement an electrical connection between the driver chip 200 and the micromirror chip 300. Refer to FIG. 22. The connector 500 may also be configured to implement an electrical connection between the driver chip 200 and a control circuit of the micromirror device.

The connector 500 may be connected to the base plate 100 through welding with a solder ball or through wire bonding.

In an example, in a solution in which the micromirror device includes the RDL 400, there may be no cabling on the surface of and inside the base plate 100. The base plate 100 does not achieve an electrical interconnection function, but achieves a supporting function.

In an example, in a solution in which the micromirror device includes the RDL 400, the lower surface of the RDL 400 may have a plurality of anchor structures (such as recesses, protrusions, or stripes) and a plurality of elastic structures, the anchor structures are connected to the elastic structures in a one-to-one manner, and the lower surface of the RDL 400 is a surface facing the base plate 100.

The RDL 400 is fastened onto the base plate 100 at the anchor structure by using a first adhesive, the RDL 400 is fastened onto the base plate 100 at a position other than the anchor structure by using a second adhesive, an elastic modulus of the first adhesive is greater than an elastic modulus of the second adhesive, and the second adhesive is flexible after being cured. For example, the first adhesive is an epoxy resin adhesive, and the second adhesive is thermally conductive silicone.

The epoxy resin adhesive is hard and has high rigidity after being cured, so that a connection between the RDL 400 and the base plate 100 is firm.

The thermally conductive silicone is soft after being cured, and can absorb residual stress in fastening between the RDL 400 and the base plate 100, so that cracking and deformation are less likely to occur between the RDL 400 and the base plate.

The elastic structure connected to the anchor structure is configured to absorb residual stress generated when the anchor structure of the RDL 400 is connected to the base plate 100 by using the epoxy resin adhesive.

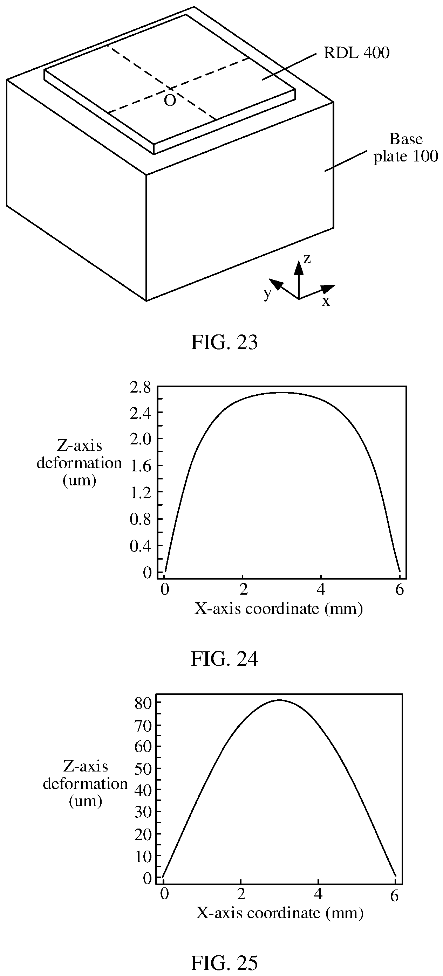

In an example, FIG. 23 is a diagram in which the RDL 400 is located on the base plate 100. Refer to FIG. 23. The RDL 400 is in a square shape or a rectangular shape. In this case, anchor structures may be disposed at four vertex positions of the RDL 400.

In an example, a central position of the RDL 400 in FIG. 23 is used as an origin of coordinates, a plane on which the RDL is located is used as an xoy plane, and a thickness direction of the RDL is used as a z-axis to establish a coordinate system. A deformation status of the RDL 400 is simulated by using simulation software.

FIG. 24 is a diagram of a curve of a relationship between an x-axis coordinate of the RDL 400 and z-axis deformation after the RDL 400 is bonded to the base plate 100 in a solution in which the RDL 400 is fastened onto the base plate 100 by entirely using an epoxy resin adhesive. FIG. 25 is a diagram of a curve of a relationship between an x-axis coordinate of the RDL 400 and z-axis deformation after the RDL 400 is bonded to the base plate 100 in a solution in which the RDL 400 is fastened onto the base plate 100 by using an epoxy resin adhesive and thermally conductive silicone based on the foregoing descriptions.

Refer to FIG. 24 and FIG. 25. The RDL 400 is bonded to the base plate 100 by using the epoxy resin adhesive and thermally conductive silicone, so that residual stress in fastening between the RDL 400 and the base plate 100 can be reduced, and deformation of the RDL 400 is less likely to occur after the bonding.

In this embodiment of the present disclosure, FIG. 16 to FIG. 22 show the solution in which the micromirror chip 300 is electrically connected to the base plate 100 or the RDL 400 through the solder ball. Compared with a solution in which the micromirror chip 300 is electrically connected to the base plate 100 or the RDL 400 through a pin connector, the solution in which an electrical connection is implemented through the solder ball is more conducive to achieving high-density arrangement, because the solder ball is small in size and a spacing between adjacent solder balls is small.

An embodiment further provides an optical device. The optical device includes a laser and the foregoing micromirror device, the laser is configured to emit an optical signal, and the micromirror device is configured to reflect an optical signal through a micromirror of the micromirror device.

The optical device may be an optical cross connect (optical cross connect, OXC) or a wavelength selective switch (wavelength selective switch, WSS) in the field of optical communication.

For example, the optical device includes two micromirror devices: a first micromirror device and a second micromirror device. In an application, an optical signal emitted by one or more lasers is incident to an optical fiber in a first optical fiber array. An optical signal emitted by the optical fiber is incident to a micromirror of the first micromirror device, is reflected to a micromirror of the second micromirror device through the micromirror of the first micromirror device, and then is reflected to an optical fiber in a second optical fiber array through the micromirror of the second micromirror device, so that the optical signal is switched from one optical fiber in the first optical fiber array to another optical fiber in the second optical fiber array.

The optical device may alternatively be a laser ranging radar in the field of laser ranging. For example, an optical signal emitted by the laser is incident to the micromirror device, and is reflected to a detected object through a micromirror of the micromirror device, and light reflected by the detected object enters a detector, to measure a distance between the detected object and the micromirror device.

## Claims

1. A micromirror chip, wherein the micromirror chip comprises a substrate (1), a micromirror array (2), electrodes (3), an optical window (4), and a fixed ring (5);
the micromirror array (2) is located on a first surface of the substrate (1), the electrodes (3) are located on a second surface of the substrate (1), and the first surface and the second surface are opposite in a thickness direction of the substrate (1); and
the fixed ring (5) is fastened onto the first surface of the substrate (1), the micromirror array (2) is located in inner space of the fixed ring (5), and the optical window (4) is fastened onto the fixed ring (5) and covers the micromirror array (2).

2. The micromirror chip according to claim 1, wherein the optical window (4) is in a flat plate shape, an included angle α is formed between the optical window (4) and the substrate (1), and the included angle α is greater than a maximum rotation angle β of rotatable micromirrors in the micromirror array (2).

3. The micromirror chip according to claim 1 or 2, wherein a height of the fixed ring (5) satisfies the following relationship:$L 1 / H 1 \geq tan \left(θ\right) , and L 2 / H 2 \geq tan \left(θ+2γ\right) .$ wherein
L1 is a minimum spacing between the fixed ring (5) and a first micromirror (21A) that is close to a direction of incident light and that is located at an array edge of the micromirror array (2), and H1 is a height of the fixed ring (5) near the first micromirror (21A);
L2 is a minimum spacing between the fixed ring (5) and a second micromirror (21B) that is close to a direction of emergent light and that is located at an array edge of the micromirror array (2), and H2 is a height of the fixed ring (5) near the second micromirror (21B); and
θ is a maximum included angle between incident light and a normal of a horizontal plane on which the substrate (1) is located, and γ is a maximum rotation angle of the second micromirror (21B).

4. The micromirror chip according to any one of claims 1 to 3, wherein a first recess is formed on an inner surface of the optical window (4), and the top of the fixed ring (5) is fastened in the first recess.

5. The micromirror chip according to any one of claims 1 to 4, wherein a second recess is formed on an inner surface of the fixed ring (5), and the optical window (4) is fastened in the second recess.

6. The micromirror chip according to any one of claims 1 to 5, wherein an antireflective film is coated on each of an outer surface and the inner surface of the optical window (4), and no antireflective film is disposed at a position at which the inner surface of the optical window (4) is fastened onto the fixed ring (5).

7. The micromirror chip according to any one of claims 1 to 6, wherein a chamfer is formed on the inner surface that is at the top of a ring wall of the fixed ring (5) and that is connected to the optical window (4).

8. The micromirror chip according to any one of claims 1 to 7, wherein an area of the top of the ring wall of the fixed ring (5) close to the optical window (4) is smaller than an area of the bottom of the ring wall of the fixed ring close to the substrate (1).

9. The micromirror chip according to any one of claims 1 to 8, wherein a groove is formed at a position at which the first surface of the substrate (1) is fastened onto the fixed ring (5), and the bottom of the fixed ring (5) is fastened in the groove.

10. The micromirror chip according to any one of claims 1 to 9, wherein roughness at the position at which the first surface of the substrate (1) is fastened onto the fixed ring (5) is greater than roughness at another position.

11. The micromirror chip according to any one of claims 1 to 10, wherein the micromirror chip further comprises a getter (6), and the getter (6) is located in the inner space of the fixed ring (5).

12. The micromirror chip according to any one of claims 1 to 11, wherein the electrodes (3) comprise a first electrode (31) and second electrodes (32) that are configured to drive the rotatable micromirrors in the micromirror array (2) to rotate;
a quantity of first electrodes (31) is greater than or equal to 1 and is less than or equal to a quantity of second electrodes (32), and the quantity of second electrodes (32) is greater than or equal to a quantity of rotatable micromirrors comprised in the micromirror array (2); and
the first electrode (31) is located on the first surface of the substrate (1) and in outer space of the fixed ring (5), and the second electrode (32) is located on the second surface of the substrate (1).

13. The micromirror chip according to any one of claims 1 to 11, wherein the electrodes (3) comprise a first electrode (31) and second electrodes (32) that are configured to drive the rotatable micromirrors in the micromirror array (2) to rotate;
a quantity of first electrodes (31) is greater than or equal to 1 and is less than or equal to a quantity of second electrodes (32), and the quantity of second electrodes (32) is greater than or equal to a quantity of rotatable micromirrors comprised in the micromirror array (2); and
both the first electrode (31) and the second electrode (32) are located on the second surface of the substrate (1).

14. The micromirror chip according to any one of claims 1 to 13, wherein the micromirror chip further comprises a conductive through-silicon via TSV layer (7), and the TSV layer (7) is located on the second surface of the substrate (1);
annular regions (71) extending in the thickness direction are formed on the TSV layer (7), and a quantity of annular regions (71) is equal to a quantity of electrodes (3) on the second surface of the substrate (1); and
the electrodes (3) on the second surface of the substrate (1) are connected, in a one-to-one manner, to inner ring regions (72) enclosed by inner rings of the annular regions (71), and each annular region (71) is filled with an insulating first medium (73).

15. The micromirror chip according to claim 14, wherein the electrodes (3) on the second surface of the substrate (1) comprise drive electrodes and a test electrode, the drive electrodes are configured to drive the rotatable micromirrors in the micromirror array (2) to rotate, and the test electrode is configured to test conductivity of the TSV layer (7) and a connected base plate (100) or RDL (400).

16. The micromirror chip according to claim 14 or 15, wherein an inner ring wall and an outer ring wall of the annular region (71) are each covered with the first medium (73); and
a second medium (74) is further filled between the first medium (73) on the inner ring wall and the first medium (73) on the outer ring wall, and a coefficient of thermal expansion of the second medium (74) is between a coefficient of thermal expansion of the first medium (73) and a coefficient of thermal expansion of a material in the inner ring region (72).

17. A micromirror device, wherein the micromirror device comprises a base plate (100), a driver chip (200), and the micromirror chip (300) according to any one of claims 1 to 16; and
the micromirror chip (300) is located on the base plate (100), and the driver chip (200) is electrically connected to the micromirror chip (300).

18. The micromirror device according to claim 17, wherein the micromirror device further comprises a re-distribution layer RDL (400), the RDL (400) is located on a surface of the base plate (100), the micromirror chip (300) is located on an upper surface of the RDL (400), and the upper surface of the RDL (400) is a surface facing away from the base plate (100).

19. The micromirror device according to claim 18, wherein the driver chip (200) is located on the upper surface of the RDL (400), and the micromirror device (300) is electrically connected to the driver chip (200) through the RDL (400).

20. The micromirror device according to claim 18, wherein the micromirror device further comprises a connector (500), and the connector (500) is located on the surface of the base plate (100); and
the micromirror chip (300) and the connector (500) are electrically connected to the base plate (100) through the RDL (400), and the connector (500) is electrically connected to the driver chip (200) through a flexible printed circuit FPC.

21. The micromirror device according to any one of claims 18 to 20, wherein a lower surface of the RDL (400) has a plurality of anchor structures and a plurality of elastic structures, the anchor structures are connected to the elastic structures in a one-to-one manner, and the lower surface of the RDL (400) is a surface facing the base plate (100); and
the RDL (400) is secured onto the base plate (100) at a position of the anchor structure by using a first adhesive, the RDL (400) is secured onto the base plate (100) at another position other than the anchor structure by using a second adhesive, an elastic modulus of the first adhesive is greater than an elastic modulus of the second adhesive, and the second adhesive is flexible after being cured.

22. An optical device, wherein the optical device comprises a laser and the micromirror device according to any one of claims 17 to 21, the laser is configured to emit an optical signal, and the micromirror device is configured to reflect an optical signal.
